# EUROPEAN PATENT APPLICATION

(11) **EP 4 742 226 A1**
(43) Date of publication of application: **13.05.2026**
(21) Application number: 23950205.7
(22) Date of filing: 31.08.2023
(51) Int. Cl.: G09G 3/32, G09G 3/3233, H10H 29/01, H10K 59/131

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN); Beijing BOE Technology Development Co., Ltd., Beijing 100176 (CN)
(72) Inventor: ZHAO, Jiao, Beijing 100176 (CN); ZHAO, Meng, Beijing 100176 (CN); GUO, Yuzhen, Beijing 100176 (CN); ZHANG, Chenyang, Beijing 100176 (CN); CUI, Xiaorong, Beijing 100176 (CN); GAO, Lipeng, Beijing 100176 (CN); ZHENG, Haoliang, Beijing 100176 (CN); XUAN, Minghua, Beijing 100176 (CN); ZHOU, Ying, Beijing 100176 (CN); GUAN, Feng, Beijing 100176 (CN); DU, Jianhua, Beijing 100176 (CN); LV, Yang, Beijing 100176 (CN); WANG, Chaolu, Beijing 100176 (CN); WANG, Yicheng, Beijing 100176 (CN); YAN, Rui, Beijing 100176 (CN); WU, Hao, Beijing 100176 (CN); XIAO, Li, Beijing 100176 (CN)
(74) Representative: CMS Cameron McKenna Nabarro Olswang LLP
(86) International application number: PCT/CN2023/116178
(87) International publication number: WO 2025/043620

(57) **Abstract**

A display substrate and a manufacturing method therefor, and a display device. The display substrate comprises a plurality of circuit units; each circuit unit comprises a pixel driving circuit, a first scanning signal line (31), a second scanning signal line (32), a third scanning signal line (33), and a light-emitting signal line (35); the pixel driving circuit comprises at least an eighth transistor (T8) and a ninth transistor (T9); the orthographic projection of the first scanning signal line (31) on the plane of the display substrate is at least partially overlapped with the orthographic projection of the second scanning signal line (32) on the plane of the display substrate; the orthographic projection of the third scanning signal line (33) on the plane of the display substrate is at least partially overlapped with the orthographic projection of the light-emitting signal line (35) on the plane of the display substrate; and the orthographic projection of the eighth transistor (T8) on the plane of the display substrate is at least partially overlapped with the orthographic projection of the ninth transistor (T9) on the plane of the display substrate.

## Description

### Technical Field

The present disclosure relates to, but is not limited to, the field of display technologies, and particularly to a display substrate and a preparation method therefor, and a display apparatus.

### Background

A Light Emitting Diode (LED) technology has been developed for nearly 30 years, from an initial solid lighting power supply to a backlight in the display field, and then to an LED display screen, providing a solid foundation for its wider applications. With development of chip manufacturing and encapsulation technologies, Mini Light Emitting Diode (Mini LED) display and Micro Light Emitting Diode (Micro LED) display have gradually become a hot spot in a display panel, and may be applied in fields such as Augmented Reality / Virtual Reality (AR/VR), Television (TV), and outdoor display.

### Summary

The following is a summary of subject matter described herein in detail. The summary is not intended to limit the scope of protection of the claims.

In one aspect, an embodiment of the present disclosure provides a display substrate including a plurality of circuit units forming a plurality of unit rows and a plurality of unit columns. At least one circuit unit includes a pixel drive circuit, a first scan signal line, a second scan signal line, a third scan signal line, and a light emitting signal line, the pixel drive circuit at least includes a first transistor, a second transistor, a third transistor, a fourth transistor, a fifth transistor, a sixth transistor, a seventh transistor, an eighth transistor, a ninth transistor, and a tenth transistor. A gate electrode of the first transistor, a gate electrode of the seventh transistor and a gate electrode of the tenth transistor are electrically connected to the third scan signal line, a gate electrode of the second transistor is electrically connected to the second scan signal line, a gate electrode of the fourth transistor is electrically connected to the first scan signal line, a gate electrode of the fifth transistor is electrically connected to the light emitting signal line, and a gate electrode of the eighth transistor is electrically connected to a gate electrode of the ninth transistor; an orthographic projection of the first scan signal line on a plane of the display substrate at least partially overlaps an orthographic projection of the second scan signal line on the plane of the display substrate, an orthographic projection of the third scan signal line on the plane of the display substrate at least partially overlaps an orthographic projection of the light emitting signal line on the plane of the display substrate, and an orthographic projection of the eighth transistor on the plane of the display substrate at least partially overlaps an orthographic projection of the ninth transistor on the plane of the display substrate.

In an exemplary implementation, the first transistor, the second transistor, the seventh transistor, the ninth transistor, and the tenth transistor are oxide transistors, and the third transistor, the fourth transistor, the fifth transistor, the sixth transistor, and the eighth transistor are polysilicon transistors.

In an exemplary implementation, an orthographic projection of the gate electrode of the eighth transistor on the plane of the display substrate overlaps at least partially an orthographic projection of the gate electrode of the ninth transistor on the plane of the display substrate.

In an exemplary implementation, an orthographic projection of an active layer of the eighth transistor on the plane of the display substrate at least partially overlaps an orthographic projection of an active layer of the ninth transistor on the plane of the display substrate.

In an exemplary implementation, an orthographic projection of a channel region of the eighth transistor on the plane of the display substrate at least partially overlaps an orthographic projection of a channel region of the ninth transistor on the plane of the display substrate.

In an exemplary implementation, in at least one unit row, pixel drive circuits in two adjacent circuit units are mirror symmetrical with respect to a column dividing line, which is a straight line located between adjacent unit columns and extending in a pixel column direction.

In an exemplary implementation, in at least one unit column, pixel drive circuits in two adjacent circuit units are mirror symmetrical with respect to a row dividing line which is a straight line located between adjacent unit rows and extending in a pixel row direction.

In an exemplary implementation, in at least one unit column, first electrodes of first transistors in two adjacent circuit units are connected to a same initial signal line, and first electrodes of seventh transistors in two adjacent circuit units are connected to a same initial signal line.

In an exemplary implementation, in at least one unit column, active layers of first transistors in two adjacent circuit units are of an interconnected integral structure, and active layers of seventh transistors in two adjacent circuit units are of an interconnected integral structure.

In an exemplary implementation, in at least one unit row, first electrodes of eighth transistors in two adjacent circuit units are connected to a same high-frequency signal line.

In an exemplary implementation, in at least one unit row, active layers of eighth transistors in two adjacent circuit units are of an interconnected integral structure.

In an exemplary implementation, in a direction perpendicular to the display substrate, the display substrate includes a first semiconductor layer, a first conductive layer, a second conductive layer, a second semiconductor layer, and a third conductive layer that are sequentially disposed on a base substrate; an active layer of the third transistor, an active layer of the fourth transistor, an active layer of the fifth transistor, an active layer of the sixth transistor and an active layer of the eighth transistor are disposed in the first semiconductor layer, the first scan signal line, the light emitting signal line and the gate electrode of the eighth transistor are disposed in the first conductive layer, an active layer of the first transistor, an active layer of the second transistor, an active layer of the seventh transistor, an active layer of the ninth transistor and an active layer of the tenth transistor are disposed in the second semiconductor layer, and the second scan signal line, the third scan signal line and the gate electrode of the ninth transistor are disposed in the third conductive layer.

In an exemplary implementation, the display substrate further includes a first shielding line disposed between the third scan signal line and the light emitting signal line in the direction perpendicular to the display substrate, an orthographic projection of the first shielding line on the base substrate at least partially overlaps an orthographic projection of the light emitting signal line on the base substrate, and the orthographic projection of the first shielding line on the base substrate at least partially overlaps an orthographic projection of the third scan signal line on the base substrate.

In an exemplary implementation, the display substrate further includes a second shielding line disposed between the first scan signal line and the second scan signal line in the direction perpendicular to the display substrate, an orthographic projection of the second shielding line on the base substrate overlaps at least partially an orthographic projection of the first scan signal line on the base substrate, and the orthographic projection of the second shielding line on the base substrate overlaps at least partially an orthographic projection of the second scan signal line on the base substrate.

In an exemplary implementation, the display substrate further includes a fourth conductive layer disposed at a side of the third conductive layer away from the base substrate; the fourth conductive layer at least includes an interconnection electrode connected with the active layer of the eighth transistor and the active layer of the ninth transistor, respectively.

In an exemplary implementation, one end of the interconnection electrode is connected to the active layer of the eighth transistor through one via, and the other end of the interconnection electrode is connected to the active layer of the ninth transistor through another via.

In an exemplary implementation, the interconnection electrode is lapped with a first surface of the active layer of the eighth transistor through one lap hole and lapped with a second surface of the active layer of the ninth transistor through the lap hole, the first surface is a surface parallel to the base substrate and the second surface is a surface intersecting the base substrate.

In an exemplary implementation, the third conductive layer further includes a transfer electrode; the transfer electrode is connected to the active layer of the eighth transistor through one transfer hole, one end of the interconnection electrode is connected to a first transfer electrode through one via, and the other end of the interconnection electrode is connected to the active layer of the ninth transistor through another via.

In an exemplary implementation, the display substrate further includes a shielding layer disposed between the first conductive layer and the second conductive layer, the shielding layer includes a transfer electrode; the transfer electrode is connected to the active layer of the eighth transistor through one transfer hole, one end of the interconnection electrode is connected to the transfer electrode through one via, and the other end of the interconnection electrode is connected to the active layer of the ninth transistor through another via.

In an exemplary implementation, the second conductive layer includes a transfer electrode; the transfer electrode is connected to the active layer of the eighth transistor through one transfer hole, and the active layer of the ninth transistor is connected to the transfer electrode through another transfer hole.

In an exemplary implementation, the display substrate further includes a shielding layer disposed between the first conductive layer and the second conductive layer, the shielding layer includes a transfer electrode; the transfer electrode is connected to the active layer of the eighth transistor through one transfer hole, and the active layer of the ninth transistor is connected to the transfer electrode through another transfer hole.

In another aspect, the present disclosure also provides a display apparatus including the display substrate described above.

In another aspect, the present disclosure also provides a preparation method for a display substrate including a plurality of circuit units forming a plurality of unit rows and a plurality of unit columns.

The preparation method includes: forming a pixel drive circuit, a first scan signal line, a second scan signal line, a third scan signal line and a light emitting signal line in at least one circuit unit, wherein the pixel drive circuit at least includes a first transistor, a second transistor, a third transistor, a fourth transistor, a fifth transistor, a sixth transistor, a seventh transistor, an eighth transistor, a ninth transistor and a tenth transistor; a gate electrode of the first transistor, a gate electrode of the seventh transistor and a gate electrode of the tenth transistor are electrically connected to the third scan signal line, a gate electrode of the second transistor is electrically connected to the second scan signal line, a gate electrode of the fourth transistor is electrically connected to the first scan signal line, a gate electrode of the fifth transistor is electrically connected to the light emitting signal line, and a gate electrode of the eighth transistor is electrically connected to a gate electrode of the ninth transistor; an orthographic projection of the first scan signal line on a plane of the display substrate at least partially overlaps an orthographic projection of the second scan signal line on the plane of the display substrate, an orthographic projection of the third scan signal line on the plane of the display substrate at least partially overlaps an orthographic projection of the light emitting signal line on the plane of the display substrate, and an orthographic projection of the eighth transistor on the plane of the display substrate at least partially overlaps an orthographic projection of the ninth transistor on the plane of the display substrate.

Other aspects of the present disclosure may be comprehended after the drawings and the detailed descriptions are read and understood.

### Brief Description of Drawings

Accompanying drawings are used for providing further understanding of technical solutions of the present disclosure, constitute a part of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, and are only intended to schematically describe contents of the present disclosure.
FIG. 1 is a schematic diagram of a planar structure of a display substrate.
FIG. 2 is a schematic diagram of a sectional structure of a display substrate.
FIG. 3 is an equivalent circuit diagram of a pixel drive circuit according to an exemplary embodiment of the present disclosure.
FIG. 4 is a schematic diagram of a structure of a display substrate according to an exemplary embodiment of the present disclosure.
FIG. 5 is a schematic diagram of a display substrate after a pattern of a first semiconductor layer is formed according to the present disclosure.
FIG. 6A and FIG. 6B are schematic diagrams of a display substrate after a pattern of a first conductive layer is formed according to the present disclosure.
FIG. 7A and FIG. 7B are schematic diagrams of a display substrate after a pattern of a second conductive layer is formed according to the present disclosure.
FIG. 8A and FIG. 8B are schematic diagrams of a display substrate after a pattern of a second semiconductor layer is formed according to the present disclosure.
FIG. 9A and FIG. 9B are schematic diagrams of a display substrate after a pattern of a third conductive layer is formed according to the present disclosure.
FIG. 10 is a schematic diagram of a display substrate after a pattern of a sixth insulating layer is formed according to the present disclosure.
FIG. 11A and FIG. 11B are schematic diagrams of a display substrate after a pattern of a fourth conductive layer is formed according to the present disclosure.
FIG. 12 is a sectional view taken in an A-A direction in FIG. 11A.
FIG. 13A and FIG. 13B are schematic diagrams of a structure of another display substrate according to an exemplary embodiment of the present disclosure.
FIG. 14 is a schematic diagram of a structure of yet another display substrate according to an exemplary embodiment of the present disclosure.
FIGS. 15A to 15E are schematic diagrams of a preparation process of the display substrate shown in FIG. 14.
FIG. 16 is a schematic diagram of a structure of still yet another display substrate according to an exemplary embodiment of the present disclosure.
FIGS. 17A to 17D are schematic diagrams of a preparation process of the display substrate shown in FIG. 16;
FIG. 18 is a schematic diagram of a structure of also still yet another display substrate according to an exemplary embodiment of the present disclosure.
FIGS. 19A to 19F are schematic diagrams of a preparation process of the display substrate shown in FIG. 18.

Reference signs are described as follows

| | | | | | |
|---|---|---|---|---|---|
| 10- | Base substrate; | 11- | First active layer; | 12- | Second active layer; |
| 13- | Third active layer; | 14- | Fourth active layer; | 15- | Fifth active layer; |
| 16- | Sixth active layer; | 17- | Seventh active layer; | 18- | Eighth active layer; |
| 19- | Ninth active layer; | 20- | Tenth active layer; | 26- | Sixth gate electrode; |
| 28- | Eighth gate electrode; | 29- | Ninth gate electrode; | 31- | First scan signal line; |
| 32- | Second scan signal line | 33- | Third scan signal line; | 34- | Fourth scan signal line; |
| 35- | Light emitting signal line; | 36- | First power supply line; | 37- | Second power supply line; |
| 38- | First shielding line; | 39- | Second shielding line; | 41- | First shelter line; |
| 42- | Second shelter line; | 43- | Third shelter line; | 44- | Shelter block; |
| 45- | Initial signal line; | 51- | First connection electrode; | 52- | Second connection electrode; |
| 53- | Third connection electrode; | 54- | Fourth connection electrode; | 55- | Fifth connection electrode; |
| 56- | Sixth connection electrode; | 57- | Seventh connection electrode; | 58- | Eighth connection electrode; |
| 61- | Data signal line; | 62- | High-frequency signal line; | 71- | First transfer electrode; |
| 72- | Second transfer electrode; | 73- | Third transfer electrode; | 74- | Fourth transfer electrode; |
| 81- | First electrode plate; | 82- | Second electrode plate; | 83- | Third electrode plate; |
| 84- | Fourth electrode plate; | 91- | First insulating layer; | 92- | Second insulating layer; |
| 93- | Third insulating layer; | 94- | Fourth insulating layer; | 95- | Fifth insulating layer; |
| 96- | Sixth insulating layer; | 97- | Shielding insulating layer; | 102- | Drive circuit layer; |
| 103- | Light emitting structure layer. | | | | |

### Detailed Description

To make the objectives, technical solutions, and advantages of the present disclosure clearer, the embodiments of the present disclosure will be described in detail below in with reference to the accompany drawings. It is to be noted that the implementations may be implemented in various forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to quantities shown in the drawings. The drawings described in the present disclosure are schematic structural diagrams only, and one implementation of the present disclosure is not limited to shapes, numerical values, or the like shown in the drawings.

Ordinal numerals "first", "second", "third", etc., in the specification are set not to form limits in quantities but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the composition elements may be changed as appropriate according to a direction according to which each composition element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art can understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In cases that transistors with opposite polarities are used, or a current direction changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification.

In the specification, a "connection" includes a case where constitute elements are connected together through an element with a certain electrical action. An "element with a certain electrical action" is not particularly limited as long as electric signals between the connected composition elements may be sent and received. Examples of the "element with the certain electrical action" not only include an electrode and a line, but also include a switch element (such as a transistor), a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulating film" may be replaced with an "insulating layer" sometimes.

In the present disclosure, a "thickness" and a "height" refer to a vertical distance between a surface of a side of a film layer away from a base substrate and a surface of a side close to the base substrate.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In the present disclosure, "about" refers to that a boundary is not defined so strictly and numerical values within a process range and a measurement error range are allowed.

A Micro LED Display/Mini LED Display is a new type of display technology, which reduces a LED to less than 100 µm and welds it on a separate drive backboard to realize addressable active driving. Because LED has the advantages of high brightness, long life, fast response time and low energy consumption, etc., the Micro LED display/Mini LED display has the advantages of high resolution and large viewing angle, etc., and has become the next generation display technology that may replace LCD and OLED in the future.

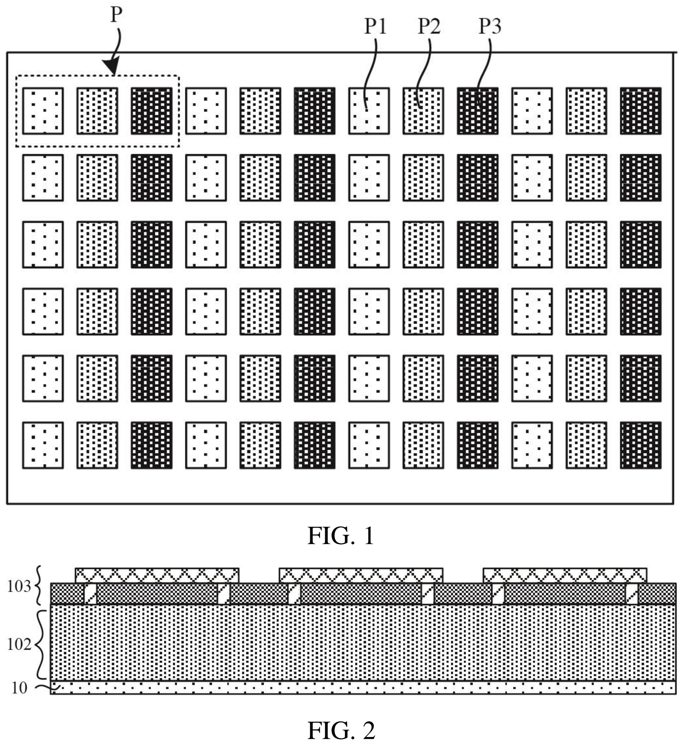

FIG. 1 is a schematic diagram of a planar structure of a display substrate. As shown in FIG. 1, in a direction parallel to the display substrate, the display substrate may include a plurality of pixel units P, and at least one pixel unit P may include a first sub-pixel P1 emitting light of a first color, a second sub-pixel P2 emitting light of a second color, and a third sub-pixel P3 emitting light of a third color. Each sub-pixel may include a circuit unit and a light emitting unit. The circuit unit may at least include a pixel drive circuit connected to a scan signal line and a data signal line, respectively. The pixel drive circuit is configured to under control of the scan signal line, receive a data voltage transmitted by the data signal line and output a corresponding current to the light emitting unit. A light emitting unit in each sub-pixel is connected with a pixel drive circuit of the sub-pixel where the light emitting unit is located, and is configured to emit light with corresponding brightness in response to a current output by the pixel drive circuit of the sub-pixel where the light emitting unit is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary embodiment, the three sub-pixels in the pixel unit P may be arranged side by side horizontally, side by side vertically, or in a manner like a Chinese character" 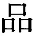 ", etc., and the present disclosure is not limited herein.

In an exemplary implementation, the pixel unit may include four sub-pixels, and the four sub-pixels may be arranged side by side horizontally, side by side vertically, in a square, in a diamond shape, or the like, which is not limited here in the present disclosure.

FIG. 2 is a schematic diagram of a sectional structure of a display substrate, illustrating a structure of three sub-pixels in a display region. As shown in FIG. 2, in a plane perpendicular to the display substrate, the display substrate may at least include a drive circuit layer 102 disposed on a base substrate 10 and a light emitting structure layer 103 disposed on one side of the drive circuit layer 102 away from the base substrate 10. In some possible implementations, the display substrate may include some other film layers such as an encapsulation structure layer and a touch structure layer, which is not limited here in the present disclosure.

In an exemplary implementation, the base substrate 10 may be a flexible base substrate, or may be a rigid base substrate. The drive circuit layer 102 may include a plurality of circuit units, each of which may at least include a pixel drive circuit formed by a plurality of transistors. The light emitting structure layer 103 may include a plurality of light emitting units, each light emitting unit may include a light emitting diode, light emitting diodes in the plurality of light emitting units are correspondingly connected with pixel drive circuits in the plurality of circuit units, and the light emitting diode is configured to emit light with corresponding brightness under drive of a current output by a corresponding pixel drive circuit.

The display substrate of the present disclosure will be described below through several examples.

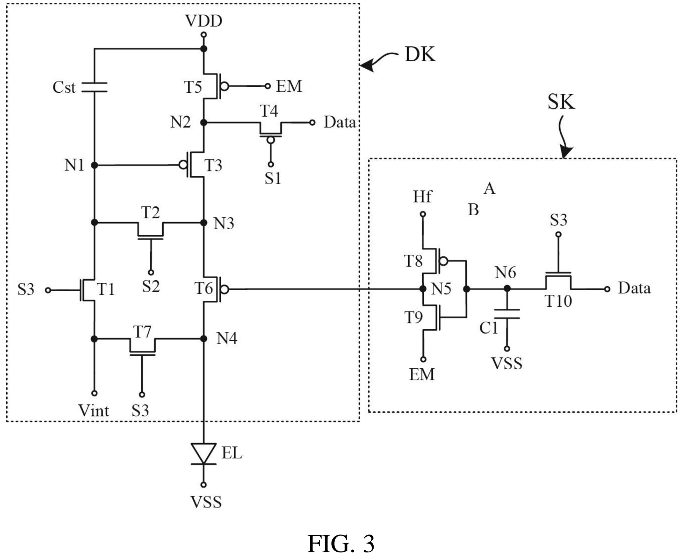

FIG. 3 is an equivalent circuit diagram of a pixel drive circuit according to an exemplary embodiment of the present disclosure, illustrating a 10T2C structure of a pixel drive circuit. As shown in FIG. 3, the pixel drive circuit according an exemplary embodiment of the present disclosure may include at least a current control sub-circuit DK and a duration control sub-circuit SK. The current control sub-circuit DK may at least include a first transistor T1, a second transistor T2, a third transistor T3, a fourth transistor T4, a fifth transistor T5, a sixth transistor T6, a seventh transistor T7, and a storage capacitor Cst, and the duration control sub-circuit SK may at least include an eighth transistor T8, a ninth transistor T9, a tenth transistor T10, and a first capacitor C1.

In an exemplary implementation, the pixel drive circuit may at least include a first node N1, a second node N2, a third node N3, a fourth node N4, a fifth node N5, and a sixth node N6. The first node N1 is respectively connected to a second electrode of the first transistor T1, a first electrode of the second transistor T2, a gate electrode of the third transistor T3 and a first terminal of the storage capacitor Cst. The second node N2 is respectively connected to a first electrode of the third transistor T3, a second electrode of the fourth transistor T4 and a second electrode of the fifth transistor T5. The third node N3 is respectively connected to a second electrode of the second transistor T2, a second electrode of the third transistor T3 and a first electrode of the sixth transistor T6. The fourth node N4 is respectively connected to a second electrode of the sixth transistor T6 and a second electrode of the seventh transistor T7. The fifth node N5 is respectively connected to a gate electrode of the sixth transistor T6, a second electrode of the eighth transistor T8 and a second electrode of the ninth transistor T9. The sixth node N6 is connected to a gate electrode of the eighth transistor T8, a gate electrode of the ninth transistor T9, a second electrode of the tenth transistor T10 and a first terminal of the first capacitor C1, respectively.

In an exemplary implementation, the gate electrode of the first transistor T1 is connected to a third scan signal line S3, the first electrode of the first transistor T1 is connected to an initial signal line Vint, and the second electrode of the first transistor T1 is connected to the first node N1.

In an exemplary implementation, the gate electrode of the second transistor T2 is connected to a second scan signal line S2, the first electrode of the second transistor T2 is connected to the first node N1, and the second electrode of the second transistor T2 is connected to the third node N3.

In an exemplary implementation, the gate electrode of the third transistor T3 is connected to the first node N1, the first electrode of the third transistor T3 is connected to the second node N2, and the second electrode of the third transistor T3 is connected to the third node N3.

In an exemplary implementation, the gate electrode of the fourth transistor T4 is connected to a first scan signal line S1, a first electrode of the fourth transistor T4 is connected to a data signal line Data, and the second electrode of the fourth transistor T4 is connected to the second node N2.

In an exemplary implementation, a gate electrode of the fifth transistor T5 is connected to a light emitting signal line EM, a first electrode of the fifth transistor T5 is connected to a first power supply line VDD, and the second electrode of the fifth transistor T5 is connected to the second node N2.

In an exemplary implementation, the gate electrode of the sixth transistor T6 is connected to the fifth node N5, the first electrode of the sixth transistor T6 is connected to the third node N3, and the second electrode of the sixth transistor T6 is connected to the fourth node N4.

In an exemplary implementation, the gate electrode of the seventh transistor T7 is connected to the third scan signal line S3, a first electrode of the seventh transistor T7 is connected to the initial signal line Vint, and the second electrode of the seventh transistor T7 is connected to the fourth node N4.

In an exemplary implementation, the gate electrode of the eighth transistor T8 is connected to the sixth node N6, a first electrode of the eighth transistor T8 is connected to a high-frequency signal line Hf, and the second electrode of the eighth transistor T8 is connected to the fifth node N5.

In an exemplary implementation, the gate electrode of the ninth transistor T9 is connected with the sixth node N6, a first electrode of the ninth transistor T9 is connected with the light emitting signal line EM, and the second electrode of the ninth transistor T9 is connected with the fifth node N5.

In an exemplary implementation, the gate electrode of the tenth transistor T10 is connected to the third scan signal line S3, a first electrode of the tenth transistor T10 is connected to the data signal line Data, and the second electrode of the tenth transistor T10 is connected to the sixth node N6.

In an exemplary implementation, the eighth transistor T8, the ninth transistor T9 and the tenth transistor T10 form an inverter structure.

In an exemplary implementation, the first terminal of the storage capacitor Cst is connected to the first node N1, and a second terminal of the storage capacitor Cst is connected to the first power supply line VDD.

In an exemplary implementation, a first terminal of the first capacitor C1 is connected to the sixth node N6, and a second terminal of the first capacitor C1 is connected to a second power supply line VSS.

In an exemplary implementation, the first transistor T1, the second transistor T2, the fourth transistor T4 to the tenth transistor T10 may be switch transistors, and the third transistor T3 may be a drive transistor.

In an exemplary implementation, the light emitting diode EL may be a Mini LED or a Micro LED. A first electrode of the light emitting diode EL is connected to the fourth node N4, and a second electrode of the light emitting diode EL is connected to the second power supply line VSS.

In an exemplary implementation, a signal of the first power supply line VDD is a continuously provided high-level signal, such as a DC high voltage. A signal of the second power supply line VSS is a continuously provided low-level signal, such as DC low voltage. A signal of the high-frequency signal line Hf is a pulse signal, and the signal of the high-frequency signal line Hf has a plurality of pulses within an image frame. In an exemplary implementation, a frequency of the signal of the high-frequency signal line Hf may be greater than a frequency of a signal of the light emitting signal line EM. For example, the frequency of the signal of the high-frequency signal line Hf may be between 3000Hz and 60000Hz, and the frequency of the light emitting signal line EM may be between 60Hz and 120Hz.

In an exemplary implementation, a plurality of light emitting diodes in the display substrate may be a current-driven type, and the pixel drive circuit shown in FIG. 3 adopts an operation mode of pulse amplitude modulation (PAM) + pulse width modulation (PWM), the PAM mode is adopted at a low current density to reduce power consumption, and the PWM mode is adopted at a high current density to reduce a large current driving state.

In an exemplary implementation, the first transistor T1 to the tenth transistor T10 may be P-type transistors or may be N-type transistors. Usage of a same type of transistors in a pixel drive circuit may simplify a process flow, reduce a process difficulty of a display panel, and improve a product yield. In some possible implementations, the first transistor T1 to the tenth transistor T10 may include a P-type transistor and an N-type transistor.

In an exemplary implementation, the first transistor T1 to the tenth transistor T10 may employ low temperature polysilicon transistors, or may employ oxide transistors, or may employ both low temperature polysilicon transistors and metal oxide transistors. Low Temperature Poly-Silicon (LTPS) is used as the active layer of the low temperature poly-silicon polysilicon, and metal oxide first semiconductor (Oxide) is used as the active layer of the metal oxide transistor. A low temperature polysilicon transistor has advantages such as a high migration rate and fast charging, and an oxide transistor has advantages such as a low drain current. The low temperature polysilicon transistor and the metal oxide transistor are integrated on one display substrate to form a Low Temperature Polycrystalline Oxide (LTPO for short) display substrate, such that advantages of the low temperature polysilicon transistor and the metal oxide transistor may be utilized, low-frequency drive can be achieved, power consumption can be reduced, and display quality can be improved.

In an exemplary implementation, in the pixel drive circuit provided by the present disclosure, the third transistor T3, the fourth transistor T4, the fifth transistor T5, the sixth transistor T6 and the eighth transistor T8 employ low temperature polysilicon transistors, and the first transistor T1, the second transistor T2, the seventh transistor T7, the ninth transistor T9 and the tenth transistor T10 employ oxide transistors, which not only can effectively reduce the leakage current of switch transistors and effectively reduce the size of the storage capacitor, but also an inverter circuit formed by the low temperature polysilicon transistors and the oxide transistors can effectively reduce the quantity of transistors of the PWM module and effectively improve the resolution.

The present disclosure provides a display substrate, which may at least include a drive circuit layer disposed on a base substrate and a light emitting structure layer disposed on a side of the drive circuit layer away from the base substrate in a plane perpendicular to the display substrate. The drive circuit layer may include a plurality of circuit units, each circuit unit may include a pixel drive circuit, and the light emitting structure layer may include a plurality of light emitting units, each light emitting unit may include a light emitting diode, light emitting diodes in the plurality of light emitting units are correspondingly connected with pixel drive circuits in the plurality of circuit units, and the light emitting diode is configured to emit light with corresponding brightness under drive of a current output by a corresponding pixel drive circuit.

In an exemplary implementation, the circuit units mentioned in the present disclosure refer to regions divided according to pixel drive circuits, and light emitting units mentioned in the present disclosure refer to regions divided according to light emitting diodes. In an exemplary implementation, positions of the light emitting units may correspond to positions of the circuit units, or positions of the light emitting units may not correspond to positions of the circuit units, which is not limited here in the present disclosure.

In an exemplary implementation, the light emitting diode described in the present disclosure may be a Mini Light Emitting Diode (Mini LED) or a Micro Light Emitting Diode (Micro LED).

An exemplary embodiment of the present disclosure provides a display substrate including a plurality of circuit units forming a plurality of unit rows and a plurality of unit columns. At least one circuit unit includes a pixel drive circuit, a first scan signal line, a second scan signal line, a third scan signal line, and a light emitting signal line. The pixel drive circuit at least includes a first transistor, a second transistor, a third transistor, a fourth transistor, a fifth transistor, a sixth transistor, a seventh transistor, an eighth transistor, a ninth transistor, and a tenth transistor. A gate electrode of the first transistor, a gate electrode of the seventh transistor and a gate electrode of the tenth transistor are electrically connected to the third scan signal line. A gate electrode of the second transistor is electrically connected to the second scan signal line. A gate electrode of the fourth transistor is electrically connected to the first scan signal line. A gate electrode of the fifth transistor is electrically connected to the light emitting signal line. A gate electrode of the eighth transistor is electrically connected to a gate electrode of the ninth transistor. An orthographic projection of the first scan signal line on a plane of the display substrate at least partially overlaps an orthographic projection of the second scan signal line on the plane of the display substrate, an orthographic projection of the third scan signal line on the plane of the display substrate at least partially overlaps an orthographic projection of the light emitting signal line on the plane of the display substrate, and an orthographic projection of the eighth transistor on the plane of the display substrate at least partially overlaps an orthographic projection of the ninth transistor on the plane of the display substrate.

In an exemplary implementation, the first transistor, the second transistor, the seventh transistor, the ninth transistor, and the tenth transistor are oxide transistors, and the third transistor, the fourth transistor, the fifth transistor, the sixth transistor, and the eighth transistor are polysilicon transistors.

In an exemplary implementation, an orthographic projection of the gate electrode of the eighth transistor on the plane of the display substrate overlaps at least partially an orthographic projection of the gate electrode of the ninth transistor on the plane of the display substrate.

In an exemplary implementation, an orthographic projection of an active layer of the eighth transistor on the plane of the display substrate at least partially overlaps an orthographic projection of an active layer of the ninth transistor on the plane of the display substrate.

In an exemplary implementation, an orthographic projection of a channel region of the eighth transistor on the plane of the display substrate at least partially overlaps an orthographic projection of a channel region of the ninth transistor on the plane of the display substrate.

In an exemplary implementation, in at least one unit row, pixel drive circuits in two adjacent circuit units are mirror symmetrical with respect to a column dividing line, which is a straight line located between adjacent unit columns and extending in a pixel column direction.

In an exemplary implementation, in at least one unit column, pixel drive circuits in two adjacent circuit units are mirror symmetrical with respect to a row dividing line which is a straight line located between adjacent unit rows and extending in a pixel row direction.

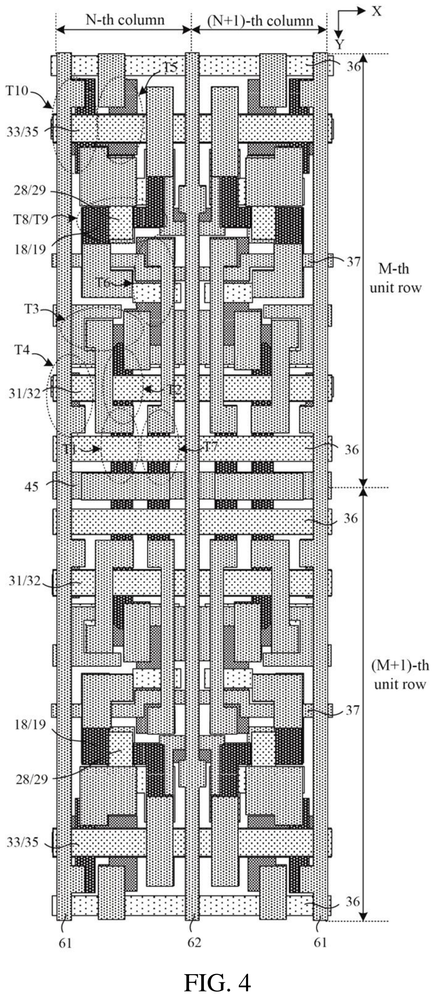

FIG. 4 is a schematic diagram of a structure of a display substrate according to an exemplary embodiment of the present disclosure. In an exemplary implementation, the display substrate may include a plurality of circuit units forming a plurality of unit rows and a plurality of unit columns, a plurality of circuit units in each unit row may be sequentially disposed along a first direction X, and a plurality of circuit units in each unit column may be sequentially disposed along a second direction Y, to form a circuit unit array arranged in an array, wherein the first direction X and the second direction Y intersect. FIG. 4 illustrates a structure of four circuit units in two unit rows (an M-th unit row and an (M+1)-th unit row) and two unit columns (an N-th unit column and an (N+1)-th unit column).

As shown in FIG. 4, at least one circuit unit may include a pixel drive circuit, and a first scan signal line 31, a second scan signal line 32, a third scan signal line 33, a light emitting signal line 35, a first power supply line 36, a second power supply line 37, an initial signal line 45, a data signal line 61, and a high-frequency signal line 62 respectively connected to the pixel drive circuit. The first scan signal line 31, the second scan signal line 32, the third scan signal line 33, the light emitting signal line 35, the first power supply line 36, the second power supply line 37, and the initial signal line 45 may be in a shape of a line in which a main body portion extends along the first direction X, and the data signal line 61 and high-frequency signal line 62 may be in a shape of a line in which a main body portion extends along the second direction Y.

In the present disclosure, structure A extends in a direction B means that structure A may include a main body portion and a secondary portion connected to the main body portion, the main body portion is substantially in the shape of a strip extending in a direction, the secondary portion is of any shape, the main body portion is at least 60% of structure A; the main body portion extends in the direction B, and a size of the main body portion extending in the direction B is larger than that of the secondary portion extending in another direction. In following description, "a structure A extends along a direction B" means that a main body portion of the structure A extends along the direction B.

In an exemplary implementation, the pixel drive circuit of the at least one circuit unit may include a storage capacitor, a first capacitor, and a plurality of transistors. The plurality of transistors may include a first transistor T1 and a seventh transistor T7 as initialization transistors, a second transistor T2 as a compensation transistor, a third transistor T3 as a drive transistor, a fourth transistor T4 and a tenth transistor T10 as data writing transistors, a fifth transistor T5 and a sixth transistor T6 as light emitting control transistors, an eighth transistor T8 as a first control transistor, and a ninth transistor T9 as a second control transistor.

In an exemplary implementation, the first transistor T1, the second transistor T2, the seventh transistor T7, the ninth transistor T9, and the tenth transistor T10 may be oxide transistors, and the third transistor T3, the fourth transistor T4, the fifth transistor T5, the sixth transistor T6, and the eighth transistor T8 may be polysilicon transistors.

In an exemplary implementation, the storage capacitor may include a first electrode plate and a third electrode plate which are stacked, the first electrode plate may serve as a gate electrode of the third transistor T3, and the third electrode plate is connected to the first power supply line 36. The first capacitor may include a second electrode plate and a fourth electrode plate which are stacked, the second electrode plate is connected to a gate electrode of the eighth transistor T8 and a gate electrode of the ninth transistor T9, respectively, and the fourth electrode plate is connected to the second power supply line 37.

In an exemplary implementation, the gate electrode of the first transistor T1, the gate electrode of the seventh transistor T7, and the gate electrode of the tenth transistor T10 are all connected to a third scan signal line 33 configured to control the turn-on and turn-off of the first transistor T1, the seventh transistor T7, and the tenth transistor T10. The first electrode of the first transistor T1 and the first electrode of the seventh transistor T7 are both connected to the initial signal line 45 configured to provide an initial signal to the first transistor T1 and the seventh transistor T7. The first electrode of the tenth transistor T10 is connected to the data signal line 61 configured to provide a data signal to the tenth transistor T10. The gate electrode of the second transistor T2 is connected to the second scan signal line 32 configured to control the turn-on and turn-off of the second transistor T2, the first electrode of the second transistor T2 is connected to the second electrode of the first transistor T1 and the gate electrode of the third transistor T3, respectively. The gate electrode of the fourth transistor T4 is connected to the first scan signal line 31 configured to control the turn-on and turn-off of the fourth transistor T4, and the first electrode of the fourth transistor T4 is connected to the data signal line 61 configured to provide a data signal to the fourth transistor T4. The gate electrode of the fifth transistor T5 is connected to the light emitting signal line 35 configured to control the turn-on and turn-off of the fifth transistor T5, and the first electrode of the fifth transistor T5 is connected to the first power supply line 36 configured to provide a first power supply signal to the fifth transistor T5. The gate electrode of the eighth transistor T8 and the gate electrode of the ninth transistor T9 are connected to each other, the first electrode of the eighth transistor T8 is connected to the high-frequency signal line 62 configured to provide a high-frequency signal to the eighth transistor T8, and the first electrode of the ninth transistor T9 is connected to the light emitting signal line 35 configured to provide a light emitting signal to the ninth transistor T9.

In an exemplary implementation, the position of the first scan signal line 31 in the circuit unit corresponds to the position of the second scan signal line 32 in the circuit unit, and an orthographic projection of the first scan signal line 31 on the plane of the display substrate at least partially overlaps an orthographic projection of the second scan signal line 32 on the plane of the display substrate.

In an exemplary implementation, the position of the third scan signal line 33 in the circuit unit corresponds to the position of the light emitting signal line 35 in the circuit unit, and an orthographic projection of the third scan signal line 33 on the plane of the display substrate at least partially overlaps an orthographic projection of the light emitting signal line 35 on the plane of the display substrate.

In an exemplary implementation, the position of the eighth transistor T8 in the circuit unit corresponds to the position of the ninth transistor T9 in the circuit unit, and an orthographic projection of the eighth transistor T8 on the plane of the display substrate at least partially overlaps an orthographic projection of the ninth transistor T9 on the plane of the display substrate.

In an exemplary implementation, the eighth transistor T8 and the ninth transistor T9 may each include a gate electrode and an active layer, and the orthographic projection of the eighth transistor T8 on the plane of the display substrate at least partially overlaps the orthographic projection of the ninth transistor T9 on the plane of the display substrate, which may include any one or more of the following: an orthographic projection of the gate electrode 28 of the eighth transistor on the plane of the display substrate at least partially overlaps an orthographic projection of the gate electrode 29 of the ninth transistor on the plane of the display substrate, an orthographic projection of the active layer 18 of the eighth transistor on the plane of the display substrate at least partially overlaps an orthographic projection of the active layer 19 of the ninth transistor on the plane of the display substrate, and an orthographic projection of a channel region of the eighth transistor T8 on the plane of the display substrate at least partially overlaps an orthographic projection of a channel region of the ninth transistor T9 on the plane of the display substrate.

In an exemplary implementation, in at least one unit row, pixel drive circuits in two adjacent circuit units may be mirror symmetrical with respect to a column dividing line, which may be a straight line located between adjacent unit columns and extending in a pixel column direction. For example, pixel drive circuits in an N-th unit column and pixel drive circuits in an (N+1)-th unit column may be mirror symmetrical with respect to a column dividing line. As another example, pixel drive circuits in the (N+1)-th unit column and pixel drive circuits in an (N+2)-th unit column may be mirror symmetrical with respect to a column dividing line. For another example, pixel drive circuits in an (N-1)-th unit column and pixel drive circuits in the N-th unit column may be mirror symmetrical with respect to a column dividing line.

In an exemplary implementation, in at least one unit column, pixel drive circuits in two adjacent circuit units may be mirror symmetrical with respect to a row dividing line, which may be a straight line located between adjacent unit rows and extending in a pixel row direction. For example, pixel drive circuits in an M-th unit row and pixel drive circuits in an (M+1)-th unit row may be mirror symmetrical with respect to a row dividing line. As another example, pixel drive circuits in the (M+1)-th unit row and pixel drive circuits in an (M+2)-th unit row may be mirror symmetrical with respect to a row dividing line. For another example, pixel drive circuits in an (M-1)-th unit row and pixel drive circuits in the M-th unit row may be mirror symmetrical with respect to a column dividing line.

In an exemplary implementation, in at least one unit column, first electrodes of the first transistors T1 in two adjacent circuit units may be connected to a same initial signal line 45, i.e., the initial signal line 45 may be disposed between two adjacent unit rows, pixel drive circuits of adjacent two unit rows share one initial signal line 45.

In an exemplary implementation, in at least one unit column, active layers of the first transistors T1 in two adjacent circuit units are of an interconnected integral structure.

In an exemplary implementation, in at least one unit row, first electrodes of the eighth transistors T8 in two adjacent circuit units are connected to a same high-frequency signal line 62, that is, the high-frequency signal line 62 may be disposed between two adjacent unit columns, and the pixel drive circuits of the adjacent two unit columns share one high-frequency signal line 62.

In an exemplary implementation, in at least one unit row, the active layers of the eighth transistors T8 in two adjacent circuit units are of an interconnected integral structure.

In an exemplary implementation, in a direction perpendicular to the display substrate, the display substrate may include a first semiconductor layer, a first conductive layer, a second conductive layer, a second semiconductor layer, a third conductive layer, and a fourth conductive layer that are sequentially disposed on the base substrate.

In an exemplary implementation, active layers of the third transistor T3, the fourth transistor T4, the fifth transistor T5, the sixth transistor T6, and the eighth transistor T8 may be disposed on the first semiconductor layer, and active layers of the first transistor T1, the second transistor T2, the seventh transistor T7, the ninth transistor T9, and the tenth transistor T10 may be disposed on the second semiconductor layer.

In an exemplary implementation, the first scan signal line 31, the light emitting signal line 35, the first power supply line 36, the gate electrode of the eighth transistor T8, the first electrode plate and the second electrode plate may be disposed on the first conductive layer; the second power supply line 37, the third electrode plate and the fourth electrode plate may be disposed on the second conductive layer; the second scan signal line 32, the third scan signal line 33 and the gate electrode of the ninth transistor T9 may be disposed on the third conductive layer; and the data signal line 61 and the high-frequency signal line 62 may be disposed on the fourth conductive layer.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition; coating may be any one or more of spray coating, spin coating, and inkjet printing; and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A coincides with the boundary of the orthographic projection of B.

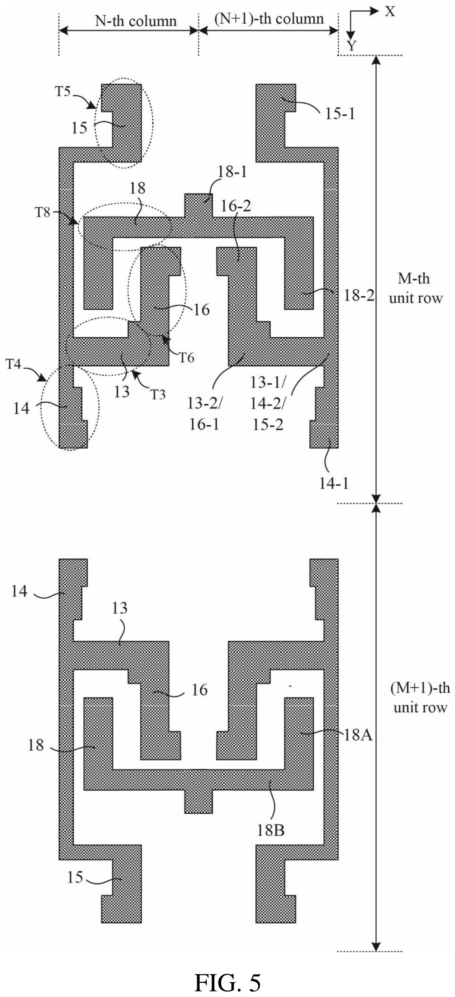

In an exemplary implementation, taking four circuit units in two unit rows (the M-th unit row and (M+1)-th unit row) and two unit columns (the N-th unit column and the (N+1)-th unit column) as an example, a preparation process of a display substrate may include following acts.
(1) A pattern of a first semiconductor layer is formed. In an exemplary implementation, forming the pattern of the first semiconductor layer may include: sequentially depositing a first insulating thin film and a first semiconductor thin film on a base substrate, patterning the first semiconductor thin film by a patterning process to form a first insulating layer disposed on the base substrate, and the pattern of the first semiconductor layer disposed on the first insulating layer, as shown in FIG. 5.

In an exemplary implementation, the pattern of the first semiconductor layer of each circuit unit may at least include a third active layer 13 of the third transistor T3, a fourth active layer 14 of the fourth transistor T4, a fifth active layer 15 of the fifth transistor T5, a sixth active layer 16 of the sixth transistor T6, and an eighth active layer 18 of the eighth transistor T8. The third active layer 13 to the sixth active layer 16 are of an interconnected integral structure, and the eighth active layer 18 is provided separately.

In an exemplary implementation, the third active layer 13 may be in a shape of a strip extending along the first direction X, the fourth active layer 14, the fifth active layer 15, and the sixth active layer 16 may be in a shape of a strip extending along the second direction Y, and the eighth active layer 18 may be in a shape of a polyline.

In an exemplary implementation, in the first direction X, the fourth active layer 14 in the N-th unit column may be located at a side of the third active layer 13 in the present circuit unit in an opposite direction of the first direction X, and the fourth active layer 14 in the (N+1)-th unit column may be located at a side of the third active layer 13 in the present circuit unit in the first direction X. The sixth active layer 16 in the N-th unit column may be located at a side of the third active layer 13 in the present circuit unit in the first direction X, and the sixth active layer 16 in the (N+1)-th unit column may be located at a side of the third active layer 13 in the present circuit unit in an opposite direction of the first direction X.

In an exemplary implementation, in the second direction Y, the fourth active layer 14 in the M-th unit row may be located at a side of the third active layer 13 in the present circuit unit in the second direction Y, and the fourth active layer 14 in the (M+1)-th unit row may be located at a side of the third active layer 13 in the present circuit unit in an opposite direction of the second direction Y. The fifth active layer 15, the sixth active layer 16, and the eighth active layer 18 in the M-th unit row may be located at a side of the third active layer 13 in the present circuit unit in an opposite direction of the second direction Y, and the fifth active layer 15, the sixth active layer 16, and the eighth active layer 18 in the (M+1)-th unit row may be located at a side of the third active layer 13 in the present circuit unit in the second direction Y.

In an exemplary implementation, the third active layer 13 to the sixth active layer 16 and the eighth active layer 18 may each include a first region, a second region and a channel region located between the first region and the second region.

In an exemplary implementation, the first region 14-1 of the fourth active layer, the first region 15-1 of the fifth active layer, the second region 16-2 of the sixth active layer, the first region 18-1 of the eighth active layer and the second region 18-2 of the eighth active layer may be separately disposed, the first region 13-1 of the third active layer, the second region 14-2 of the fourth active layer and the second region 15-2 of the fifth active layer may be connected to each other, and the second region 13-2 of the third active layer and the first region 16-1 of the sixth active layer may be connected to each other, i.e., the first region 13-1 of the third active layer may serve as the second region 14-2 of the fourth active layer and the second region 15-2 of the fifth active layer simultaneously, the second region 13-2 of the third active layer may serve as the first region 16-1 of the sixth active layer.

In an exemplary implementation, in one unit row, the first regions 16-1 of the eighth active layers in some adjacent two circuit units may be connected to each other, such that the eighth active layers in some adjacent two circuit units are of an interconnected integral structure. For example, the first regions of the eighth active layers in the N-th unit column and the first regions 18-1 of the eighth active layers in the (N+1)-th unit column may be connected to each other. As another example, the first regions of the eighth active layers in the (N+2)-th unit column and the first regions of the eighth active layers in an (N+3)-th unit column may be connected to each other. For another example, the first regions of the eighth active layers in the (N-2)-th unit column and the first regions of the eighth active layers in the (N-1)-th unit column may be connected to each other. Since the first region of the eighth active layer in each circuit unit is configured to be connected with a subsequently formed high-frequency signal line, the first regions of the eighth active layers of adjacent circuit units are formed into an interconnected integral structure, so that two unit columns may share one high-frequency signal line, which can not only reduce one high-frequency signal line and a corresponding via, reduce the occupied area of the pixel drive circuit and improve the resolution, but also ensure that the first electrodes of the eighth transistors T8 of adjacent circuit units have a same potential, beneficial to improving uniformity of the panel, avoiding a poor display of the display substrate and ensuring a display effect of the display substrate.

In an exemplary implementation, the eighth active layer 18 may include a first sub-segment 18A and a second sub-segment 18B connected to each other, the first sub-segment 18A may be in a shape of a strip extending along the second direction Y, and the second sub-segment 18B may be in a shape of a strip extending along the first direction X. A first end of the first sub-segment 18A is located at a side of the third active layer 13 away from the fourth active layer 14; a second end of the first sub-segment 18A, after extending in the direction away from the third active layer 13 in the second direction Y, is connected to a first end of the second sub-segment 18B; and a second end of the second sub-segment 18B, after extending in the direction away from the first sub-segment 18A in the first direction X, is connected to the eighth active layer 18 in an adjacent circuit unit in the first direction X. In an exemplary implementation, the first end of the first sub-segment 18A may serve as the second region of the eighth active layer, the second end of the second sub-segment 18B may serve as the first region of the eighth active layer, and the channel region of the eighth active layer may be located in the second sub-segment 18B.

In an exemplary implementation, the first semiconductor layers of adjacent unit columns may be mirror symmetrical with respect to a column dividing line. For example, the first semiconductor layers in the N-th unit column and the first semiconductor layers in the (N+1)-th unit column may be mirror symmetrical with respect to a column dividing line. As another example, the first semiconductor layers in the (N+1)-th unit column and the first semiconductor layers in the (N+2)-th unit column may be mirror symmetrical with respect to a column dividing line. For another example, the first semiconductor layers in the (N-1)-th unit column and the first semiconductor layers in the N-th unit column may be mirror symmetrical with respect to a column dividing line.

In an exemplary implementation, the first semiconductor layers of adjacent unit rows may be mirror symmetrical with respect to a row dividing line. For example, the first semiconductor layers in the M-th unit row and the first semiconductor layers in the (M+1)-th unit row may be mirror symmetrical with respect to a row dividing line. As another example, the first semiconductor layers in the (M+1)-th unit row and the first semiconductor layers in the (M+2)-th unit row may be mirror symmetrical with respect a the row dividing line. For another example, the first semiconductor layers in the (M-1)-th unit row and the first semiconductor layers in the M-th unit row may be mirror symmetrical with respect to a column dividing line.

In an exemplary implementation, the first semiconductor layer may be made of polysilicon (p-Si), i.e., the third transistor to the sixth transistor T6 and the eighth transistor T8 are LTPS transistors. In an exemplary implementation, patterning the first semiconductor thin film through the patterning process may include: forming an amorphous silicon (a-si) thin film on the second insulating thin film, dehydrogenating the amorphous silicon thin film, and crystallizing the dehydrogenated amorphous silicon thin film to form a polysilicon thin film. Subsequently, the polysilicon thin film is patterned to form the pattern of the first semiconductor layer.

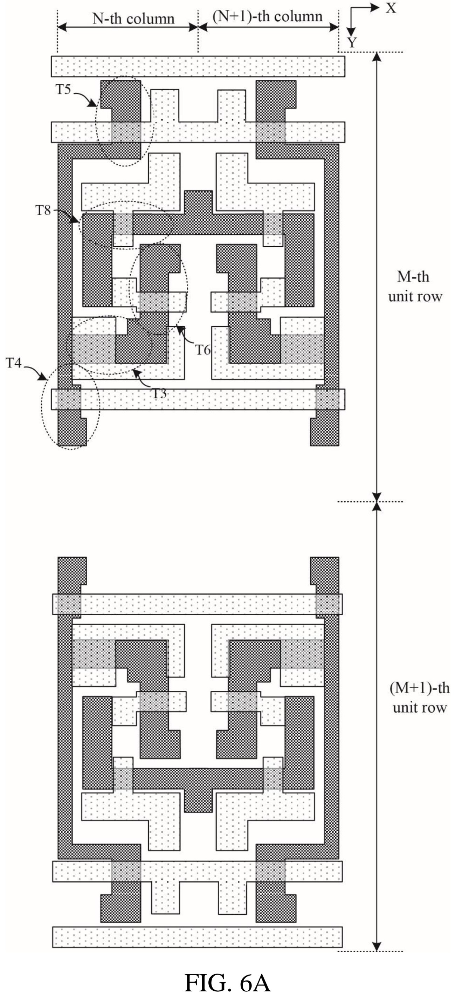

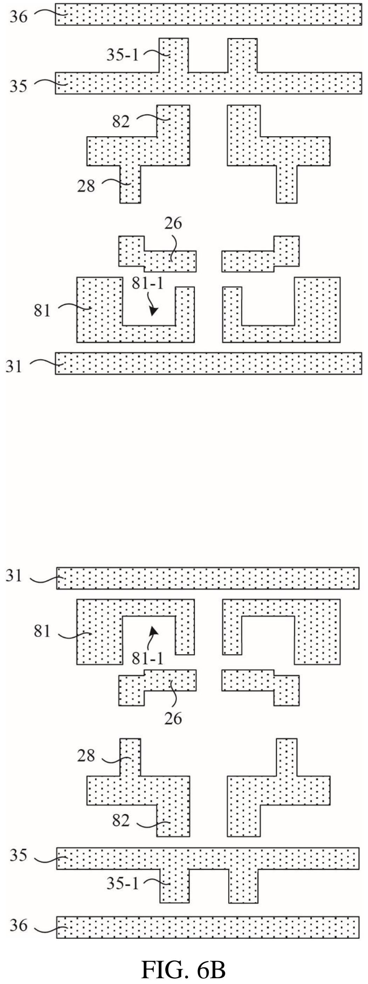

(2) A pattern of a first conductive layer is formed. In an exemplary implementation, forming the pattern of the first conductive layer may include: depositing sequentially a second insulating thin film and a first conductive thin film on the base substrate on which the aforementioned patterns are formed, and patterning the first conductive thin film through a patterning process to form a second insulating layer that covers a pattern of the first semiconductor layer and form the pattern of the first conductive layer arranged on the second insulating layer, as shown in FIG. 6A and FIG. 6B, and FIG. 6B is a schematic planar view of the first conductive layer in FIG. 6A. In an exemplary implementation, the first conductive layer may be referred to as a first gate metal (GATE1) layer.

In an exemplary implementation, the pattern of the first conductive layer of each circuit unit at least includes a sixth gate electrode 26, an eighth gate electrode 28, a first scan signal line 31, a light emitting signal line 35, a first power supply line 36, a first electrode plate 81, and a second electrode plate 82.

In an exemplary implementation, the sixth gate electrode 26 may be in a shape of a strip extending along the first direction X, an orthographic projection of the sixth gate electrode 26 on the base substrate at least partially overlaps an orthographic projection of the sixth active layer on the base substrate, and a region where the sixth gate electrode 26 overlaps the sixth active layer may serve as a gate electrode of the sixth transistor T6. In an exemplary implementation, the sixth gate electrode 26 is configured to be connected to a sixth connection electrode formed subsequently.

In an exemplary implementation, the eighth gate electrode 28 may be in a shape of a strip extending along the second direction Y, an orthographic projection of the eighth gate electrode 28 on the base substrate at least partially overlaps an orthographic projection of the eighth active layer on the base substrate, and a region where the eighth gate electrode 28 overlaps the eighth active layer may serve as a gate electrode of the eighth transistor T8. In an exemplary implementation, the eighth gate electrode 28 is configured to be connected to a subsequently formed seventh connection electrode.

In an exemplary implementation, the first electrode plate 81 may be in a shape of a rectangle, corners of the rectangle may be provided with chamfers, the first electrode plate 81 may be disposed at a side of the sixth gate electrode 26 away from the eighth gate electrode 28, and an orthographic projection of the first electrode plate 81 on the base substrate overlaps at least partially an orthographic projection of the third active layer of the third transistor T3 on the base substrate. In an exemplary implementation, the first electrode plate 81 may simultaneously serve as a lower electrode plate of the storage capacitor and a gate electrode of the third transistor T3.

In an exemplary implementation, the first electrode plate 81 may be provided with a first opening 81-1, which may be in a shape of a rectangle and may be located at a side of the first electrode plate 81 away from the first scan signal line, so that the first electrode plate 81 is formed in a "U" shape or an inverted "U" shape. The first opening 81-1 exposes a second insulating layer covering the first semiconductor layer, and an orthographic projection of the first opening 81-1 on the base substrate overlaps at least partially an orthographic projection of the second region of the third active layer on the base substrate. In an exemplary implementation, the first opening 81-1 is configured to accommodate a subsequently formed fourth via V4 that is located within the first opening 81-1 and exposes the second region of the third active layer (also the first region of the sixth active layer), so that a subsequently formed second connection electrode is connected to the second region of the third active layer (also the first region of the sixth active layer).

In an exemplary implementation, the second electrode plate 82 may be in a shape of a rectangle, corners of the rectangle may be provided with chamfers, the second electrode plate 82 may be disposed at a side of the eighth gate electrode 28 away from the sixth gate electrode 26, and the second electrode plate 82 may serve as a lower electrode plate of the first capacitor.

In an exemplary implementation, the second electrode plate 82 may be connected to the eighth gate electrode 28, such that the lower electrode plate of the first capacitor (the first terminal of the first capacitor) and the gate electrode of the eighth transistor T8 have a same potential.

In an exemplary implementation, the eighth gate electrode 28 and the second electrode plate 82 may be an interconnected integral structure.

In an exemplary implementation, the first scan signal line 31 may be in a shape of a straight line or a polyline in which a main body portion extends along the first direction X, and a region where the first scan signal line 31 overlaps the fourth active layer may serve as a gate electrode of the fourth transistor T4. In an exemplary implementation, the first scan signal line 31 in the M-th unit row may be located at a side of the first electrode plate 81 in the present circuit unit in the second direction Y, and the first scan signal line 31 in the (M+1)-th unit row may be located at a side of the first electrode plate 81 in the present circuit unit in an opposite direction of the second direction Y.

In an exemplary implementation, the light emitting signal line 35 may be in a shape of a straight line or a polyline in which a main body portion extends along the first direction X, and a region where the light emitting signal line 35 overlaps the fifth active layer may serve as a gate electrode of the fifth transistor T5. In an exemplary implementation, the light emitting signal line 35 in the M-th unit row may be located at a side of the second electrode plate 82 in the present circuit unit in an opposite direction of the second direction Y. The light emitting signal line 35 in the (M+1)-th unit row may be located at a side of the second electrode plate 82 in the present circuit unit in the second direction Y.

In an exemplary implementation, the light emitting signal line 35 of each circuit unit is connected with a light emitting connection block 35-1, the light emitting connection block 35-1 may be in a shape of a strip extending along the second direction Y, a first end of the light emitting connection block 35-1 is connected to the light emitting signal line 35, a second end of the light emitting connection block 35-1 extends in a direction away from the second electrode plate 82, and the light emitting connection block 35-1 is configured to be connected to an eighth connection electrode formed subsequently.

In an exemplary implementation, in the second direction Y, the sixth gate electrode 26, the eighth gate electrode 28, the first electrode plate 81, and the second electrode plate 82 may be disposed between the first scan signal line 31 and the light emitting signal line 35.

In an exemplary implementation, the first power supply line 36 may be in a shape of a straight line or a polyline in which a main body portion extends along the first direction X, and the first power supply line 36 may be located at a side of the light emitting signal line 35 away from the first scan signal line 31 in the present circuit unit.

In an exemplary implementation, the first conductive layers of adjacent unit columns may be mirror symmetrical with respect to a column dividing line. For example, the first conductive layers in the N-th unit column and the first conductive layers in the (N+1)-th unit column may be mirror symmetrical with respect to a column dividing line. As another example, the first conductive layers in the (N+1)-th unit column and the first conductive layers in the (N+2)-th unit column may be mirror symmetrical with respect to a column dividing line. For another example, the first conductive layers in the (N-1)-th unit column and the first conductive layers in the N-th unit column may be mirror symmetrical with respect to a column dividing line.

In an exemplary implementation, the first conductive layers of adjacent unit rows may be mirror symmetrical with respect to a row dividing line. For example, the first conductive layers in the M-th unit row and the first conductive layers in the (M+1)-th unit row may be mirror symmetrical with respect to a row dividing line. As another example, the first conductive layers in the (M+1)-th unit row and the first conductive layers in the (M+2)-th unit row may be mirror symmetrical with respect to a row dividing line. For another example, the first conductive layers in the (M-1)-th unit row and the first conductive layers in the M-th unit row may be mirror symmetrical with respect to a column dividing line.

In an exemplary implementation, after the pattern of the first conductive layer is formed, the first semiconductor layer may be subjected to a conductive treatment by using the first conductive layer as a shelter. The first semiconductor layer in a region sheltered by the first conductive layer, forms channel regions of the third transistors T3 to the sixth transistors T6 and the eighth transistor T8, and the first semiconductor layer in a region not sheltered by the first conductive layer, is treated to be conductive, that is, first regions and second regions of the third transistors T3 to the sixth transistors T6 and the eighth transistor T8 are all treated to be conductive.

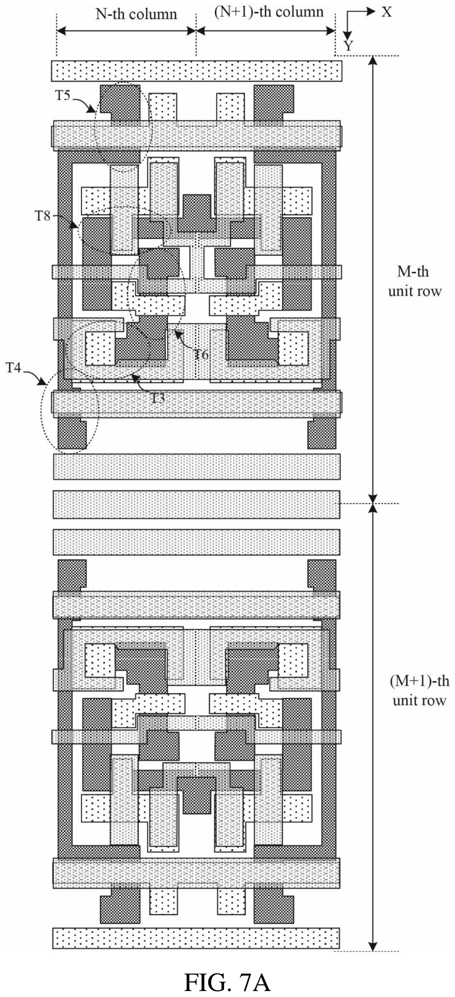

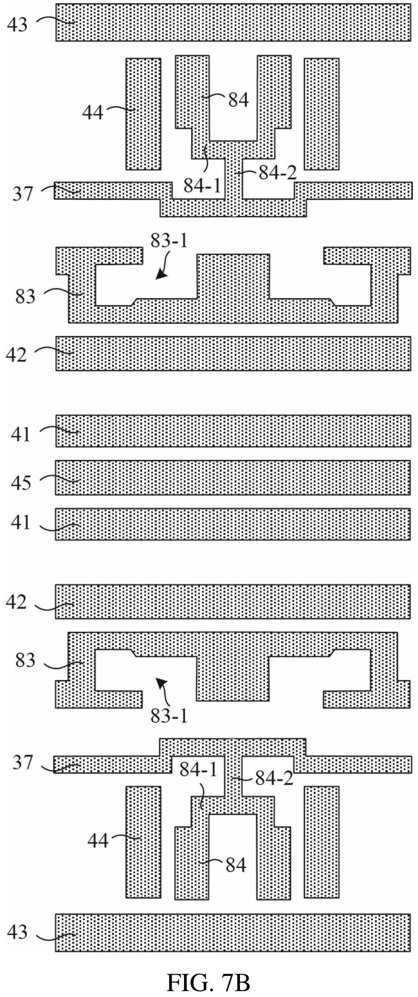

(3) A pattern of a second conductive layer is formed. In an exemplary implementation, forming the pattern of the second conductive layer may include: a third insulating thin film and a second conductive thin film are sequentially deposited on the base substrate on which the aforementioned patterns are formed, and the second conductive thin film is patterned through a patterning process to form a third insulating layer that covers the first conductive layer and the pattern of the second conductive layer arranged on the third insulating layer, as shown in FIG. 7A and FIG. 7B. FIG. 7B is a schematic planar view of the second conductive layer in FIG. 7A. In an exemplary implementation, the second conductive layer may be referred to as a second gate metal (GATE2) layer.

In an exemplary implementation, the pattern of the second conductive layer of each circuit unit at least includes a second power supply line 37, a first shelter line 41, a second shelter line 42, a third shelter line 43, a shelter block 44, an initial signal line 45, a third electrode plate 83, and a fourth electrode plate 84.

In an exemplary implementation, the second power supply line 37 may be in a shape of a straight line or a polyline in which a main body portion extends along the first direction X. The second power supply line 37 may be located between the sixth gate electrode 26 and the eighth gate electrode 28 in the present circuit unit.

In an exemplary implementation, the first shelter line 41 may be in a shape of a straight line or a polyline in which a main body portion extends along the first direction X. The first block line 41 in the M-th unit row may be located at a side of the first scan signal line 31 in the present circuit unit in the second direction Y, and the first block line 41 in the (M+1)-th unit row may be located at a side of the first scan signal line 31 in the present circuit unit in an opposite direction of the second direction Y. In an exemplary implementation, the first shelter line 41 is configured to serve as a shelter layer of the first transistor T1 and the seventh transistor T7 to shelter channel regions of the first transistor T1 and the seventh transistor T7 and ensure electrical performance of the first transistor T1 and the seventh transistor T7 which are oxide, and at the same time is configured to serve as a bottom gate electrode of the first transistor T1 and the seventh transistor T7.

In an exemplary implementation, the second shelter line 42 may be in a shape of a straight line or a polyline in which a main body portion extends along the first direction X, and may be located between the first electrode plate 81 and the first shelter line 41 in the present circuit unit, and an orthographic projection of the second shelter line 42 on the base substrate at least partially overlaps an orthographic projection of the first scan signal line 31 on the base substrate. In an exemplary implementation, the second shelter line 42 is configured to serve as a shelter layer of the second transistor T2 to shelter a channel region of the second transistor T2 and ensure the electrical performance of the second transistor T2 which is oxide, while is configured to serve as a bottom gate electrode of the second transistor T2.

In an exemplary implementation, the third shelter line 43 may be in a shape of a straight line or a polyline in which a main body portion extends along the first direction X, and may be located at a side of the second electrode plate 82 away from the first scan signal line 31 in the present circuit unit, and an orthographic projection of the third shelter line 43 on the base substrate at least partially overlaps an orthographic projection of the light emitting signal line 35 on the base substrate. In an exemplary implementation, the third shelter line 43 is configured as a shelter layer of the tenth transistor T10 to shelter a channel region of the tenth transistor T10 and ensure the electrical performance of the tenth transistor T10 which is oxide, while is configured to serve as a bottom gate electrode of the tenth transistor T10.

In an exemplary implementation, the shelter block 44 may be in a shape of a strip extending along the second direction Y, and an orthographic projection of the shelter block 44 on the base substrate overlaps at least partially an orthographic projection of the eighth gate electrode 28 on the base substrate. In an exemplary implementation, the shelter block 44 is configured to serve as a shelter layer of the ninth transistor T9 to shelter a channel region of the ninth transistor T9 and ensure the electrical performance of the ninth transistor T9 which is oxide, while is configured to serve as a bottom gate electrode of the ninth transistor T9.

In an exemplary implementation, the initial signal line 45 may have a shape of a straight line or a polyline in which a main body portion extends along the first direction X, and may be located at a side of the first shelter line 41 away from the second shelter line 42 in the present circuit unit.

In an exemplary implementation, the initial signal line 45 may be disposed between the M-th unit row and the (M+1)-th unit row, such that pixel drive circuits in the M-th unit row and pixel drive circuits in the (M+1)-th unit row share one initial signal line 45, that is, the initial signal line 45 in the M-th unit row and the initial signal line 45 in the (M+1)-th unit row may be a same signal line.

By arranging two adjacent unit rows to share one initial signal line in the present disclosure, an initial signal line and a corresponding via can be reduced, the occupied area of the pixel drive circuit can be reduced and the resolution can be improved, it can be ensured that first electrodes of the first transistors T1 and first electrodes of the seventh transistors T7 in adjacent unit rows have a same potential, beneficial to improving uniformity of the panel, avoiding a poor display of the display substrate and ensuring a display effect of the display substrate.

In an exemplary implementation, a contour of the third electrode plate 83 may be in a shape of a rectangle, corners of the rectangle may be provided with chamfers, an orthographic projection of the third electrode plate 83 on the base substrate and an orthographic projection of the first electrode plate 81 on the base substrate at least partially overlap, the third electrode plate 83 may serve as an upper electrode plate of the storage capacitor, and the first electrode plate 81 and the third electrode plate 83 form the storage capacitor of the pixel drive circuit.

In an exemplary implementation, the third electrode plate 83 is provided with a second opening 83-1, which may be in a shape of a rectangle and located at a side of the third electrode plate 83 away from the first scan signal line, so that the third electrode plate 83 has an annular structure with an opening. The second opening 83-1 exposes not only the third insulating layer covering the first electrode plate 81, but also the second insulating layer and the third insulating layer covering the first semiconductor layer, an orthographic projection of the second opening 83-1 on the base substrate overlaps at least partially an orthographic projection of the first electrode plate 81 on the base substrate, and an orthographic projection of the second opening 83-1 on the base substrate overlaps at least partially an orthographic projection of the second region of the third active layer on the base substrate. In an exemplary implementation, the second opening 83-1 is configured to accommodate a fourth via and a fifteenth via which are subsequently formed, the fourth via is located within the second opening 83-1 and exposes the second region of the third active layer, so that a subsequently formed second connection electrode is connected to the second region of the third active layer, and the fifteenth via is located within the second opening 83-1 and exposes the first electrode plate 81, so that a subsequently formed first connection electrode is connected to the first electrode plate 81.

In an exemplary implementation, the third plates 83 in two adjacent circuit units in a unit row may be an interconnected integral structure. For example, the third plate 83 in the N-th column and the third plate 83 in the (N+1)-th unit column may be connected to each other. For another example, the third electrode plate 83 in the (N+2)-th column and the third electrode plate 83 in the (N+3) unit column may be connected to each other. For another example, the third electrode plate 83 in the (N-2)-th column and the third electrode plate 83 in the (N-1)-th unit column may be connected to each other. In an exemplary implementation, the third electrode plate of the integral structure may extend to a bezel region and be connected to a first power supply line in the bezel region. In the present disclosure, by forming the third plates of adjacent circuit units into an interconnected integral structure, the third plate of the integral structure may be reused as a lateral power supply signal line, which can ensure that a plurality of third plates in a unit row have a same potential, is beneficial to improving uniformity of the panel, avoiding a poor display of the display substrate and ensuring a display effect of the display substrate.

In an exemplary implementation, a contour of the fourth electrode plate 84 may be in a shape of a rectangle, corners of the rectangle may be provided with chamfers, an orthographic projection of the fourth electrode plate 84 on the base substrate overlaps at least partially an orthographic projection of the second electrode plate 82 on the base substrate, the fourth electrode plate 84 may serve as an upper electrode plate of the first capacitor, and the second electrode plate 82 and the fourth electrode plate 84 form the first capacitor of the pixel drive circuit.

In an exemplary implementation, the fourth electrode plate 84 in each circuit unit may be provided with a first electrode plate connection strip 84-1, a first end of which is connected to the fourth electrode plate 84 of the present circuit unit, and a second end of which is extended in the direction of an adjacent circuit unit and then connected to the first electrode plate connection strip 84-1 of the adjacent circuit unit, so that the fourth electrode plates 84 of some adjacent circuit units in a unit row are connected to each other.

In an exemplary implementation, the fourth electrode plate 84 and the first electrode plate connection strip 84-1 in each circuit unit may be an interconnected integral structure, and the fourth electrode plates 84 of some adjacent circuit units in a unit row form an interconnected integral structure through the plate connection strips 84-1. By forming the fourth electrode plates of adjacent circuit units into an interconnected integral structure in the present disclosure, the occupied area of the pixel drive circuit can be reduced and the resolution can be improved, it can be ensured that the fourth electrode plates of the adjacent circuit units have a same potential, beneficial to improving uniformity of the panel, avoiding a poor display of the display substrate and ensuring a display effect of the display substrate.

In an exemplary implementation, each circuit unit may further include a second electrode plate connection strip 84-2. The second electrode plate connection strip 84-2 may be in a shape of a strip extending along the second direction Y, and is disposed between the first electrode plate connection strip 84-1 and the second power supply line 37. A first end of the second electrode plate connection strip 84-2 is connected to the first electrode plate connection strip 84-1, and a second end of the second electrode plate connection strip 84-2 is connected to the second power supply line 37. Since the first electrode plate connection strip 84-1 is connected to the fourth electrode plate 84, thereby the connection between the fourth electrode plate 84 and the second power supply line 37 is realized, and the fourth electrode plate 84 has the potential of the second power supply line 37.

In an exemplary implementation, in at least one circuit unit, the second power supply line 37, the fourth electrode plate 84, the first electrode plate connection strip 84-1, and the second electrode plate connection strip 84-2 may be an interconnected integral structure.

In an exemplary implementation, the second conductive layers of adjacent unit columns may be mirror symmetrical with respect to a column dividing line. For example, the second conductive layers in the N-th unit column and the second conductive layers in the (N+1)-th unit column may be mirror symmetrical with respect to a column dividing line. As another example, the second conductive layers in the (N+1)-th unit column and the second conductive layers in the (N+2)-th unit column may be mirror symmetrical with respect to a column dividing line. For another example, the second conductive layers in the (N-1)-th unit column and the second conductive layers in the N-th unit column may be mirror symmetrical with respect to a column dividing line.

In an exemplary implementation, the second conductive layers of adjacent unit rows may be mirror symmetrical with respect to a row dividing line. For example, the second conductive layers in the M-th unit row and the second conductive layers in the (M+1)-th unit row may be mirror symmetrical with respect to a row dividing line. As another example, the second conductive layers in the (M+1)-th unit row and the second conductive layers in the (M+2)-th unit row may be mirror symmetrical with respect to a row dividing line. For another example, the second conductive layers in the (M-1)-th unit row and the second conductive layers in the M-th unit row may be mirror symmetrical with respect to a column dividing line.

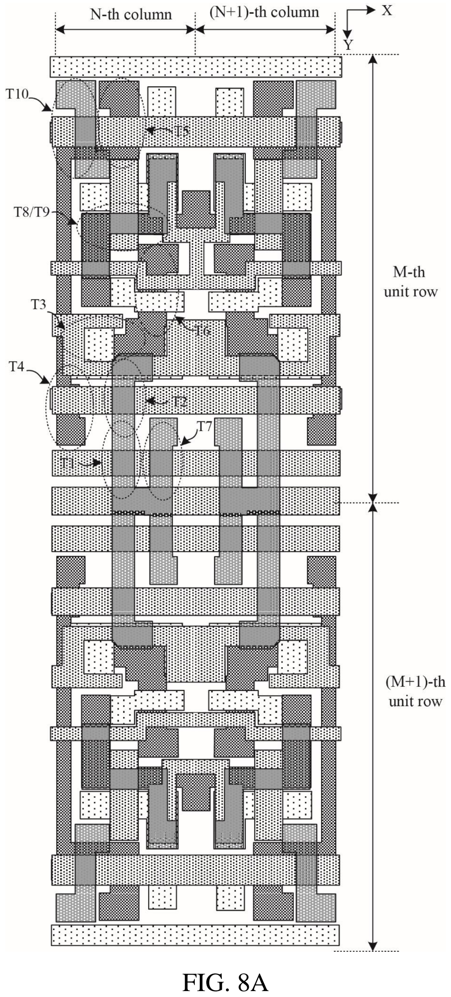

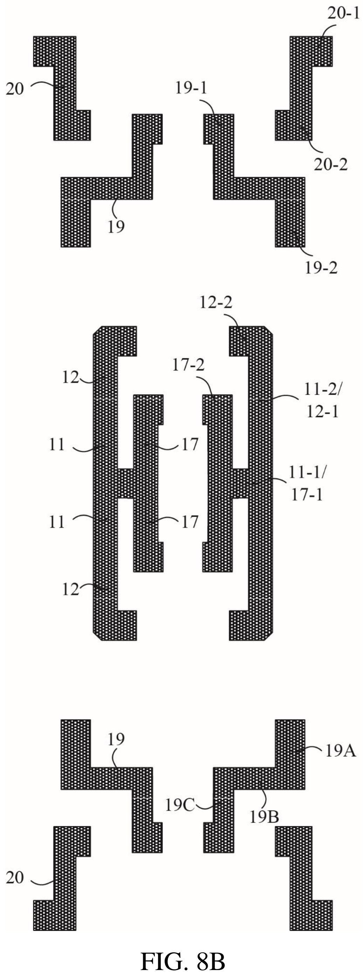

(4) A pattern of a second semiconductor layer is formed. In an exemplary implementation, forming the pattern of the second semiconductor layer may include: sequentially depositing a fourth insulating thin film and a second semiconductor thin film on the base substrate on which the aforementioned patterns are formed, patterning the second semiconductor thin film through a patterning process to form a fourth insulating layer covering the second conductive layer, and the pattern of the second semiconductor layer disposed on the fourth insulating layer, as shown in FIGS. 8A and 8B, FIG. 8B is a schematic planar view of the second semiconductor layer in FIG. 8A.

In an exemplary implementation, the pattern of the second semiconductor layer of each circuit unit at least includes a first active layer 11 of the first transistor T1, a second active layer 12 of the second transistor T2, a seventh active layer 17 of the seventh transistor T7, a ninth active layer 19 of the ninth transistor T9, and a tenth active layer 20 of the tenth transistor T10. The first active layer 11, the second active layer 12, and the seventh active layer 17 may be an interconnected integral structure, and the ninth active layer 19 and the tenth active layer 20 are separately disposed.

In an exemplary implementation, the first active layer 11, the second active layer 12, the seventh active layer 17, and the tenth active layer 20 may be in a shape of a strip extending along the second direction Y, and the ninth active layer 19 may be in a shape of polyline.

In an exemplary implementation, in the first direction X, the seventh active layer 17 in the N-th unit column may be located on a side of the first active layer 11 in the present circuit unit in the first direction X, and the seventh active layer 17 in the (N+1)-th unit column may be located on a side of the first active layer 11 in the present circuit unit in an opposite direction of the first direction X.

In an exemplary implementation, in the second direction Y, the second active layer 12, the ninth active layer 19, and the tenth active layer 20 in the M-th unit row may be located at a side of the first active layer 11 in the present circuit unit in an opposite direction of the second direction Y, and the second active layer 12, the ninth active layer 19, and the tenth active layer 20 in the (M+1)-th unit row may be located on a side of the first active layer 11 in the present circuit unit in the second direction Y. The ninth active layer 19 may be located on a side of the second active layer 12 away from the first active layer 11, and the tenth active layer 20 may be located on a side of the ninth active layer 19 away from the first active layer 11.

In an exemplary implementation, the first active layer 11, the second active layer 12, the seventh active layer 17, the ninth active layer 19, and the tenth active layer 20 may each include a first region, a second region, and a channel region located between the first region and the second region.

In an exemplary implementation, the second region 12-2 of the second active layer, the second region 17-2 of the seventh active layer, the first region 19-1 of the ninth active layer, the second region 19-2 of the ninth active layer, the first region 20-1 of the tenth active layer and the second region 20-2 of the tenth active layer may be separately disposed, the second region 11-2 of the first active layer and the first region 12-1 of the second active layer may be connected to each other, and the first region 11-2 of the first active layer and the first region 17-1 of the seventh active layer may be connected to each other, i.e., the second region 11-2 of the first active layer may serve as the first region 12-1 of the second active layer, and the first region 11-2 of the first active layer may serve as the first region 17-1 of the seventh active layer.

In an exemplary implementation, in a unit column, the first active layers in some adjacent two circuit units may be an interconnected integral structure, and the seventh active layers in some adjacent two circuit units may be an interconnected integral structure. For example, the first regions of the first active layer and the seventh active layer of the M-th unit row and the first regions of the first active layer and the seventh active layer of the M-th unit row may be connected to each other. As another example, the first regions of the first active layer and the seventh active layer of the (M+2)-th unit row and the first regions of the first active layer and the seventh active layer of an (M+3)-th unit row may be connected to each other. The first regions of the first active layer and the seventh active layer of an (M-2)-th unit row and the first regions of the first active layer and the seventh active layer of the (M-1)-th unit row may be connected to each other. Since the first regions of the first active layer and the seventh active layer in each circuit unit are configured to be connected with the initial signal line, by forming the first active layers and the seventh active layers of adjacent circuit units as an interconnected integral structure, the two unit rows can share an initial signal line, which not only reduces an initial signal line and a corresponding via, reduces the occupied area of the pixel drive circuit and improves the resolution, but also ensures that the first electrodes of the first transistors T1 and the first electrodes of the seventh transistors T7 of adjacent circuit units have a same potential, beneficial to improving uniformity of the panel, avoiding a poor display of the display substrate and ensuring a display effect of the display substrate.

In an exemplary implementation, an orthographic projection of the ninth active layer 19 on the base substrate at least partially overlaps an orthographic projection of the shelter block 44 on the base substrate, so that the shelter block 44 may shelter the channel region of the ninth active layer 19 while serving as the bottom gate electrode of the ninth transistor T9.

In an exemplary implementation, the orthographic projection of the ninth active layer 19 on the base substrate at least partially overlaps an orthographic projection of the eighth active layer 18 on the base substrate, so that the eighth transistor T8 and the ninth transistor T9 are formed as a stacked transistor structure, and the ninth transistor T9 is located at a side of the eighth transistor T8 away from the base substrate, which can effectively reduce the occupied area of the pixel drive circuit and facilitate the improvement of resolution.

In an exemplary implementation, the ninth active layer 19 may include a third sub-segment 19A, a fourth sub-segment 19B, and a fifth sub-segment 19C connected sequentially, the third sub-segment 19A and the fifth sub-segment 19C may be in a shape of a strip extending along the second direction Y, and the fourth sub-segment 19B may be in a shape of a strip extending along the first direction X. A first end of the third sub-segment 19A is located at a side of the first electrode plate 81 away from the first scan line 31, a second end of the third sub-segment 19A, after extending in a direction away from the first electrode plate 81 in the second direction Y, is connected to a first end of the fourth sub-segment 19B, and a second end of the fourth sub-segment 19B, after extending in a direction away from the third sub-segment 19A in the first direction X, is connected to a first end of the fifth sub-segment 19C, and a second end of the fifth sub-segment 19C extends in a direction away from the first electrode plate 81 in the second direction Y. In an exemplary implementation, the first end of the third sub-segment 19A may serve as the second region of the ninth active layer, the second end of the fifth sub-segment 19C may serve as the first region of the ninth active layer, and the channel region of the ninth active layer may be located in the fourth sub-segment 19B.

In an exemplary implementation, an orthographic projection of the third sub-segment 19A of the ninth active layer 19 on the base substrate at least partially overlaps an orthographic projection of the first sub-segment 18A of the eighth active layer 18 on the base substrate, and an orthographic projection of the fourth sub-segment 19B of the ninth active layer 19 on the base substrate at least partially overlaps an orthographic projection of the second sub-segment 18B of the eighth active layer 18 on the base substrate.

In an exemplary implementation, an orthographic projection of the third sub-segment 19A of the ninth active layer 19 on the base substrate may be within a range of an orthographic projection of the first sub-segment 18A of the eighth active layer 18 on the base substrate, and an orthographic projection of the fourth sub-segment 19B of the ninth active layer 19 on the base substrate may be within a range of an orthographic projection of the second sub-segment 18B of the eighth active layer 18 on the base substrate.

In an exemplary implementation, a first width of the third sub-segment 19A of the ninth active layer 19 may be substantially the same as a first width of the first sub-segment 18A of the eighth active layer 18, and the first width may be a size in the first direction X.

In an exemplary implementation, a first extension length of the third sub-segment 19A of the ninth active layer 19 may be smaller than a first extension length of the first sub-segment 18A of the eighth active layer 18, and the first extension length may be a dimension in the second direction Y.

In an exemplary implementation, a second width of the fourth sub-segment 19B of the ninth active layer 19 may be substantially the same as a second width of the second sub-segment 18B of the eighth active layer 18, and the second width may be a dimension in the second direction Y.

In an exemplary implementation, a second extension length of the fourth sub-segment 19B of the ninth active layer 19 may be smaller than a second extension length of the second sub-segment 18B of the eighth active layer 18, and the second extension length may be a dimension in the first direction X.

In an exemplary implementation, the second semiconductor layers of adjacent unit columns may be mirror symmetrical with respect to a column dividing line. For example, the second semiconductor layers in the N-th unit column and the second semiconductor layers in the (N+1)-th unit column may be mirror symmetrical with respect to a column dividing line. As another example, the second semiconductor layers in the (N+1)-th unit column and the second semiconductor layers in the (N+2)-th unit column may be mirror symmetrical with respect to a column dividing line. For another example, the second semiconductor layers in the (N-1)-th unit column and the second semiconductor layers in the N-th unit column may be mirror symmetrical with respect to a column dividing line.

In an exemplary implementation, the second semiconductor layers of adjacent unit rows may be mirror symmetrical with respect to a row dividing line. For example, the second semiconductor layers in the M-th unit row and the second semiconductor layers in the (M+1)-th unit row may be mirror symmetrical with respect to a row dividing line. As another example, the second semiconductor layers in the (M+1)-th unit row and the second semiconductor layers in the (M+2)-th unit row may be mirror symmetrical with respect to a row dividing line. For another example, the second semiconductor layers in the (M-1)-th unit row and the second semiconductor layers in the M-th unit row may be mirror symmetrical with respect to a column dividing line.

In an exemplary implementation, the second semiconductor layer may be made of an oxide, i.e., the eighth transistor T8 is an oxide transistor. In an exemplary implementation, the second semiconductor thin film may be made of Indium Gallium Zinc Oxide (IGZO), wherein electron mobility of the Indium Gallium Zinc Oxide (IGZO) is higher than that of amorphous silicon.

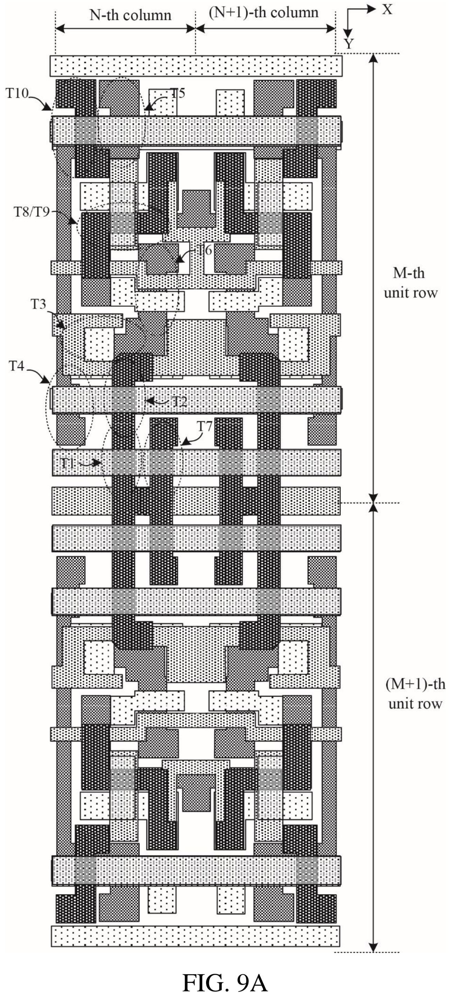

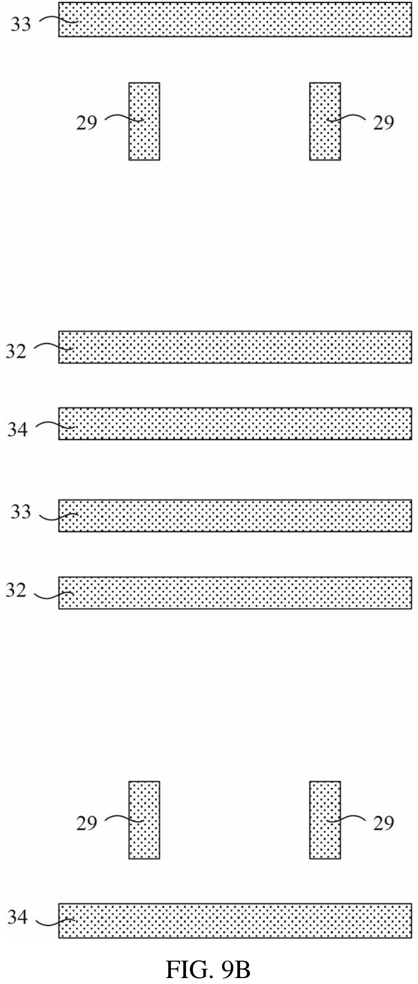

(5) A pattern of a third conductive layer is formed. In an exemplary implementation, forming the pattern of the third conductive layer may include: on the base substrate on which the aforementioned patterns are formed, depositing a fifth insulating thin film and a third conductive thin film sequentially, and patterning the third conductive thin film by a patterning process to form a fifth insulating layer covering the second semiconductor layer and the pattern of the third conductive layer disposed on the fifth insulating layer, as shown in FIGs. 9A and 9B, FIG.9B is a schematic planar view of the third conductive layer in FIG. 9A. In an exemplary implementation, the second conductive layer may be referred to as a third gate metal (GATE3) layer.

In an exemplary implementation, the pattern of the third conductive layer of each circuit unit at least includes a ninth gate electrode 29, a second scan signal line 32, a third scan signal line 33 and a fourth scan signal line 34.

In an exemplary implementation, the ninth gate electrode 29 may be in a shape of a strip extending along the second direction Y, an orthographic projection of the ninth gate electrode 29 on the base substrate at least partially overlaps an orthographic projection of the ninth active layer on the base substrate, and a region where the ninth gate electrode 29 overlaps the ninth active layer may serve as a gate electrode of the ninth transistor T9. In an exemplary implementation, the ninth gate electrode 29 is configured to be connected to a seventh connection electrode formed subsequently.

In an exemplary implementation, an orthographic projection of the ninth gate electrode 29 on the base substrate overlaps at least partially an orthographic projection of the shelter block 44 on the base substrate. In an exemplary implementation, the ninth gate electrode 29 may be connected to the shelter block 44 through a subsequently formed seventh connection electrode, so that the shelter block 44 may serve as a bottom gate electrode of the ninth transistor T9, and the ninth gate electrode 29 may serve as a top gate electrode of the ninth transistor T9, and a ninth transistor T9 of a top gate and bottom gate structure is formed.

In an exemplary implementation, an orthographic projection of the ninth gate electrode 29 on the base substrate at least partially overlaps an orthographic projection of the eighth gate electrode 28 on the base substrate, and an orthographic projection of the channel region of the ninth transistor T9 on the base substrate at least partially overlaps an orthographic projection of the channel region of the eighth transistor T8 on the base substrate, so that the eighth transistor T8 and the ninth transistor T9 form a stacked transistor structure, the ninth transistor T9 is located on a side of the eighth transistor T8 away from the base substrate, effectively reducing the occupied area of the pixel drive circuit and facilitating the improvement of the resolution.

In an exemplary implementation, the second scan signal line 32 may be in a shape of a straight line or a polyline in which a main body portion extends along the first direction X, and a region where the second scan signal line 32 overlaps the second active layer may serve as a gate electrode of the second transistor T2. In an exemplary implementation, the position of the second scan signal line 32 corresponds to the position of the second shelter line 42, and an orthographic projection of the second scan signal line 32 on the base substrate overlaps at least partially an orthographic projection of the second shelter line 42 on the base substrate.

In an exemplary implementation, the second scan signal line 32 and the second shelter line 42 may be connected to a same signal source, such that the second shelter line 42 may serve as a bottom gate electrode of the second transistor T2, and the second scan signal line 32 may serve as a top gate electrode of the second transistor T2, and a second transistor T2 of a top gate and bottom gate structure is formed.

In an exemplary implementation, the position of the second scan signal line 32 corresponds to the position of the first scan signal line 31, and an orthographic projection of the second scan signal line 32 on the base substrate at least partially overlaps an orthographic projection of the first scan signal line 31 on the base substrate, so that the first scan signal line 31 and the second scan signal line 32 form a stacked signal line structure, and the second scan signal line 32 is located at a side of the first scan signal line 31 away from the base substrate, which can effectively reduce the occupied area of the pixel drive circuit and facilitate the improvement of the resolution.

In an exemplary implementation, the third scan signal line 33 may be in a shape of a straight line or a polyline in which a main body portion extends along the first direction X, and a region where the third scan signal line 33 overlaps the tenth active layer may serve as a gate electrode of the tenth transistor T10. In an exemplary implementation, the position of the third scan signal line 33 corresponds to the position of the third shelter line 43, and an orthographic projection of the third scan signal line 33 on the base substrate at least partially overlaps an orthographic projection of the third shelter line 43 on the base substrate.

In an exemplary implementation, the third scan signal line 33 and the third shelter line 43 may be connected to a same signal source, so that the third shelter line 43 may serve as a bottom gate electrode of the tenth transistor T10, and the third scan signal line 33 may serve as a top gate electrode of the tenth transistor T10, a tenth transistor T10 of a top gate and bottom gate structure is formed.

In an exemplary implementation, the position of the third scan signal line 33 corresponds to the position of the light emitting signal line 35, an orthographic projection of the third scan signal line 33 on the base substrate at least partially overlaps an orthographic projection of the light emitting signal line 35 on the base substrate, so that the third scan signal line 33 and the light emitting signal line 35 form a stacked signal line structure, the third scan signal line 33 is located at a side of the light emitting signal line 35 away from the base substrate, which can effectively reduce the occupied area of the pixel drive circuit and facilitate the improvement of the resolution.

In an exemplary implementation, the fourth scan signal line 34 may be in a shape of a straight line or a polyline in which a main body portion extends along the first direction X, and regions where the fourth scan signal line 34 overlaps the first active layer and the seventh active layer may serve as a gate electrode of the first transistor T1 and a gate electrode of the seventh transistor T7, respectively. In an exemplary implementation, the position of the fourth scan signal line 34 corresponds to the position of the first shelter line 41, and an orthographic projection of the fourth scan signal line 34 on the base substrate overlaps at least partially an orthographic projection of the first shelter line 41 on the base substrate.

In an exemplary implementation, the fourth scan signal line 34 and the first shelter line 41 may be connected to a same signal source, such that the first shelter line 41 may serve as the bottom gate electrode of the first transistor T1 and a bottom gate electrode of the seventh transistor T7, respectively, and the fourth scan signal line 34 may serve as a top gate electrode of the first transistor T1 and a top gate electrode of the seventh transistor T7, respectively, a first transistor T1 of a top gate and bottom gate structure and a seventh transistor T7 of a top gate and bottom gate structure are formed.

In an exemplary implementation, the third scan signal line 33 and the fourth scan signal line 34 may be connected to a same signal source, and the third scan signal line 33 and the fourth scan signal line 34 may synchronously control the turn-on and turn-off of the first transistor T1, the seventh transistor T7, and the tenth transistor T10.

In an exemplary implementation, the third conductive layers of adjacent unit columns may be mirror symmetrical with respect to a column dividing line. For example, the third conductive layers in the N-th unit column and the third conductive layers in the (N+1)-th unit column may be mirror symmetrical with respect to a column dividing line. As another example, the third conductive layers in the (N+1)-th unit column and the third conductive layers in the (N+2)-th unit column may be mirror symmetrical with respect to a column dividing line. For another example, the third conductive layers in the (N-1)-th unit column and the third conductive layers in the N-th unit column may be mirror symmetrical with respect to a column dividing line.

In an exemplary implementation, the third conductive layers of adjacent unit rows may be mirror symmetrical with respect to a row dividing line. For example, the third conductive layers in the M-th unit row and the third conductive layers in the (M+1)-th unit row may be mirror symmetrical with respect to a row dividing line. As another example, the third conductive layers in the (M+1)-th unit row and the third conductive layers in the (M+2)-th unit row may be mirror symmetrical with respect to a row dividing line. For another example, the third conductive layers in the (M-1)-th unit row and the third conductive layers in the M-th unit row may be mirror symmetrical with respect to a column dividing line.

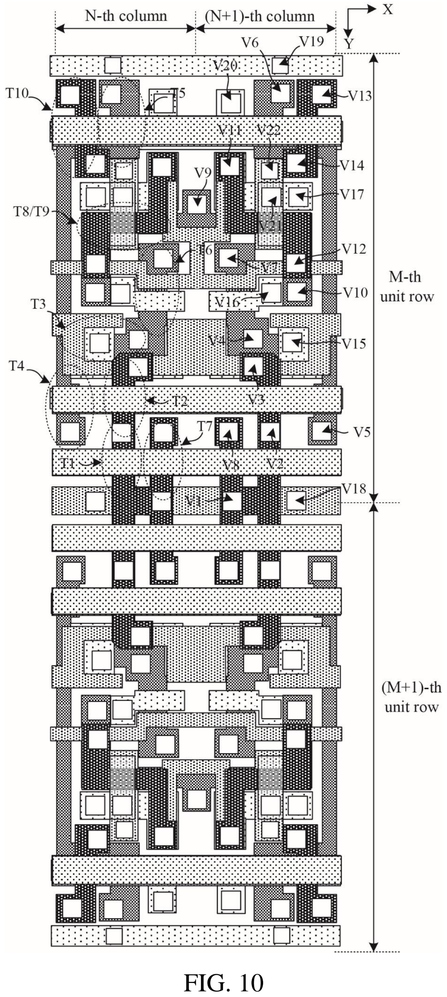

(6) A pattern of a sixth insulating layer is formed. In an exemplary implementation, forming the pattern of the sixth insulating layer may include: depositing a sixth insulating thin film on the base substrate on which the aforementioned patterns are formed, patterning the fifth insulating thin film using a patterning process to form the sixth insulating layer covering the third conductive layer, wherein a plurality of vias are provided on the sixth insulating layer, as shown in FIG. 10.

In an exemplary implementation, a plurality of vias of each circuit unit at least includes a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, a fourteenth via V14, a fifteenth via V15, a sixteenth via V16, a seventeenth via V17, an eighteenth via V18, a nineteenth via V19, a twentieth via V20, a twenty-first via V21, and a twenty-second via V22.

In an exemplary implementation, an orthographic projection of the first via V1 on the base substrate is within a range of an orthographic projection of the first region of the first active layer (also the first region of the seventh active layer) on the base substrate, the sixth insulating layer and the fifth insulating layer within the first via V1 are etched away to expose a surface of the first region of the first active layer, and the first via V1 is configured such that a subsequently formed third connection electrode is connected to the first region of the first active layer (also the first region of the seventh active layer) through the via.

In an exemplary implementation, an orthographic projection of the second via V2 on the base substrate is within a range of an orthographic projection of the second region of the first active layer (also the first region of the second active layer) on the base substrate, the sixth insulating layer and the fifth insulating layer within the second via V2 are etched away to expose a surface of the second region of the first active layer, and the second via V2 is configured such that a first connection electrode subsequently formed is connected to the second region of the first active layer (also the first region of the second active layer) through this via.

In an exemplary implementation, an orthographic projection of the third via V3 on the base substrate is within a range of an orthographic projection of the second region of the second active layer on the base substrate, the sixth insulating layer and the fifth insulating layer within the third via V3 are etched away to expose a surface of the second region of the second active layer, and the third via V3 is configured such that a subsequently formed second connection electrode is connected to the second region of the second active layer through the via.

In an exemplary implementation, an orthographic projection of the fourth via V4 on the base substrate is within a range of an orthographic projection of the first opening 81-1 of the first electrode plate 81 on the base substrate, the sixth insulating layer, the fifth insulating layer, the fourth insulating layer, the third insulating layer and the second insulating layer within the fourth via V4 are etched away to expose a surface of the second region of the third active layer (also the first region of the sixth active layer), and the fourth via V4 is configured such that a subsequently formed second connection electrode is connected to the second region of the third active layer (also the first region of the sixth active layer) through the via.

In an exemplary implementation, an orthographic projection of the fifth via V5 on the base substrate is within a range of an orthographic projection of the first region of the fourth active layer on the base substrate, the sixth insulating layer, the fifth insulating layer, the fourth insulating layer, the third insulating layer and the second insulating layer within the fifth via V5 are etched away to expose a surface of the first region of the fourth active layer, and the fifth via V5 is configured such that a subsequently formed data signal line is connected to the first region of the fourth active layer through the via.

In an exemplary implementation, an orthographic projection of the sixth via V6 on the base substrate is within a range of an orthographic projection of the first region of the fifth active layer on the base substrate, the sixth insulating layer, the fifth insulating layer, the fourth insulating layer, the third insulating layer and the second insulating layer within the sixth via V6 are etched away to expose a surface of the first region of the fifth active layer, and the sixth via V6 is configured such that a subsequently formed fourth connection electrode is connected to the first region of the fifth active layer through the via.

In an exemplary implementation, an orthographic projection of the seventh via V7 on the base substrate is within a range of an orthographic projection of the second region of the sixth active layer on the base substrate, the sixth insulating layer, the fifth insulating layer, the fourth insulating layer, the third insulating layer and the second insulating layer within the seventh via V7 are etched away to expose a surface of the second region of the sixth active layer, and the seventh via V7 is configured such that a subsequently formed fifth connection electrode is connected to the second region of the sixth active layer through the via.

In an exemplary implementation, an orthographic projection of the eighth via V8 on the base substrate is within a range of an orthographic projection of the second region of the seventh active layer on the base substrate, the sixth insulating layer and the fifth insulating layer within the eighth via V8 are etched away to expose a surface of the second region of the seventh active layer, and the eighth via V8 is configured such that a subsequently formed fifth connection electrode is connected to the second region of the seventh active layer through the via.

In an exemplary implementation, an orthographic projection of the ninth via V9 on the base substrate is within a range of an orthographic projection of the first region of the eighth active layer on the base substrate, the sixth insulating layer, the fifth insulating layer, the fourth insulating layer, the third insulating layer and the second insulating layer within the ninth via V9 are etched away to expose a surface of the first region of the eighth active layer, and the ninth via V9 is configured such that a subsequently formed high-frequency signal line is connected to the first region of the eighth active layer through the via.

In an exemplary implementation, since the first regions of the eighth active layers of some adjacent circuit units in a unit row are connected to each other, some adjacent circuit units in a unit row may share a ninth via V9.

In an exemplary implementation, an orthographic projection of the tenth via V10 on the base substrate is within a range of an orthographic projection of the second region of the eighth active layer on the base substrate, the sixth insulating layer, the fifth insulating layer, the fourth insulating layer, the third insulating layer and the second insulating layer within the tenth via V10 are etched away to expose a surface of the second region of the eighth active layer, and the tenth via V10 is configured such that a subsequently formed sixth connection electrode is connected to the second region of the eighth active layer through the via.

In an exemplary implementation, an orthographic projection of the eleventh via V11 on the base substrate is within a range of an orthographic projection of the first region of the ninth active layer on the base substrate, the sixth insulating layer and the fifth insulating layer within the eleventh via V11 are etched away to expose a surface of the first region of the ninth active layer, and the eleventh via V11 is configured such that a subsequently formed eighth connection electrode is connected to the first region of the ninth active layer through the via.

In an exemplary implementation, an orthographic projection of the twelfth via V12 on the base substrate is within a range of an orthographic projection of the second region of the ninth active layer on the base substrate, the sixth insulating layer and the fifth insulating layer within the twelfth via V12 are etched away to expose a surface of the second region of the ninth active layer, and the twelfth via V12 is configured such that a subsequently formed sixth connection electrode is connected to the second region of the ninth active layer through the via.

In an exemplary implementation, an orthographic projection of the thirteenth via V13 on the base substrate is within a range of an orthographic projection of the first region of the tenth active layer on the base substrate, the sixth insulating layer and the fifth insulating layer within the thirteenth via V13 are etched away to expose a surface of the first region of the tenth active layer, and the thirteenth via V13 is configured such that a subsequently formed data signal line is connected to the first region of the tenth active layer through the via.

In an exemplary implementation, an orthographic projection of the fourteenth via V14 on the base substrate is within a range of an orthographic projection of the second region of the tenth active layer on the base substrate, the sixth insulating layer and the fifth insulating layer within the fourteenth via V14 are etched away to expose a surface of the second region of the tenth active layer, and the fourteenth via V14 is configured such that a subsequently formed seventh connection electrode is connected to the second region of the tenth active layer through the via.

In an exemplary implementation, an orthographic projection of the fifteenth via V15 on the base substrate is within a range of an orthographic projection of the second opening 83-1 of the third electrode plate 83 on the base substrate, the sixth insulating layer, the fifth insulating layer, the fourth insulating layer and the third insulating layer in the fifteenth via V15 are etched away to expose a surface of the first electrode plate 81, and the fifteenth via V15 is configured such that a subsequently formed first connection electrode is connected to the first electrode plate 81 through the via.

In an exemplary implementation, an orthographic projection of the sixteenth via V16 on the base substrate is within a range of an orthographic projection of the sixth gate electrode 26 on the base substrate, the sixth insulating layer, the fifth insulating layer, the fourth insulating layer and the third insulating layer within the sixteenth via V16 are etched away to expose a surface of the sixth gate electrode 26, and the sixteenth via V16 is configured such that a subsequently formed sixth connection electrode is connected to the sixth gate electrode 26 through the via.

In an exemplary implementation, an orthographic projection of the seventeenth via V17 on the base substrate is within a range of an orthographic projection of the eighth gate electrode 28 on the base substrate, the sixth insulating layer, the fifth insulating layer, the fourth insulating layer, and the third insulating layer within the seventeenth via V17 are etched away to expose a surface of the eighth gate electrode 28, and the seventeenth via V17 is configured such that a subsequently formed seventh connection electrode is connected to the eighth gate electrode 28 through the via.

In an exemplary implementation, an orthographic projection of an eighteenth via V18 on the base substrate is within a range of an orthographic projection of the initial signal line 45 on the base substrate, the sixth insulating layer, the fifth insulating layer, and the fourth insulating layer within the eighteenth via V18 are etched away to expose a surface of the initial signal line 45, and the eighteenth via V18 is configured such that a subsequently formed third connection electrode is connected to the initial signal line 45 through the via.

In an exemplary implementation, since adjacent circuit units in a unit column share one initial signal line 45, adjacent circuit units in a unit column may share one first via V1 and one eighteenth via V18.

In an exemplary implementation, an orthographic projection of the nineteenth via V19 on the base substrate is within a range of an orthographic projection of the first power supply line 36 on the base substrate, and the sixth insulating layer, fifth insulating layer, fourth insulating layer and third insulating layer within the nineteenth via V19 are etched away to expose a surface of the first power supply line 36, the nineteenth via V19 is configured such that a subsequently formed fourth connection electrode is connected to the first power supply line 36 through the via.

In an exemplary implementation, an orthographic projection of the twentieth via V20 on the base substrate is within a range of an orthographic projection of the light emitting connection block 35-1 of the light emitting signal line 35 on the base substrate, the sixth insulating layer, the fifth insulating layer, the fourth insulating layer and the third insulating layer in the twentieth via V20 are etched away to expose a surface of the light emitting connection block 35-1, and the twentieth via V20 is configured such that a subsequently formed eighth connection electrode is connected to the light emitting connection block 35-1 through the via.

In an exemplary implementation, an orthographic projection of the twenty-first via V21 on the base substrate is within a range of an orthographic projection of the ninth gate electrode 29 on the base substrate, the sixth insulating layer in the twenty-first via V21 is etched away to expose a surface of the ninth gate electrode 29, and the twenty-first via V21 is configured such that a subsequently formed seventh connection electrode is connected to the ninth gate electrode 29 through the via.

In an exemplary implementation, an orthographic projection of the twenty-second via V22 on the base substrate is within a range of an orthographic projection of the shelter block 44 on the base substrate, the sixth insulating layer, the fifth insulating layer, and the fourth insulating layer within the twenty-second via V22 are etched away to expose a surface of the shelter block 44, and the twenty-second via V22 is configured such that a subsequently formed seventh connection electrode is connected to the shelter block 44 through the via.

In an exemplary implementation, this patterning process may include two patterning processes, which may be ILD-L MASK and ILD-O MASK, respectively.

In an exemplary implementation, a plurality of vias of adjacent unit columns may be mirror symmetrical with respect to a column dividing line. For example, a plurality of vias in the N-th unit column and a plurality of vias in the (N+1)-th unit column may be mirror symmetrical with respect to a column dividing line. As another example, a plurality of vias in the (N+1)-th unit column and a plurality of vias in the (N+2)-th unit column may be mirror symmetrical with respect to a column dividing line. For another example, the plurality of vias in the (N-1)-th unit column and the plurality of vias in the N-th unit column may be mirror symmetrical with respect to a column dividing line.

In an exemplary implementation, a plurality of vias of adjacent unit rows may be mirror symmetrical with respect to a row dividing line. For example, a plurality of vias in the M-th unit row and a plurality of vias in the (M+1)-th unit row may be mirror symmetrical with respect to a row dividing line. As another example, a plurality of vias in the (M+1)-th unit row and a plurality of vias in the (M+2)-th unit row may be mirror symmetrical with respect to a row dividing line. For another example, a plurality of vias in the (M-1)-th unit row and a plurality of vias in the M-th unit row may be mirror symmetrical with respect to a column dividing line.

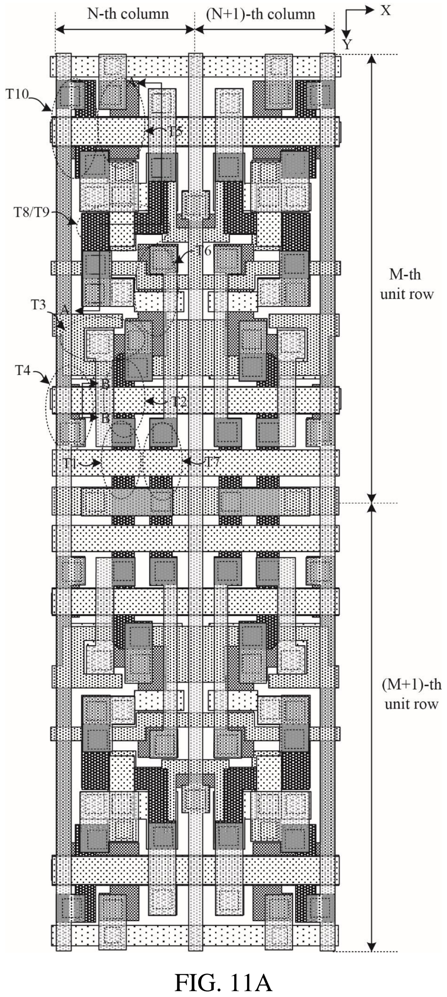

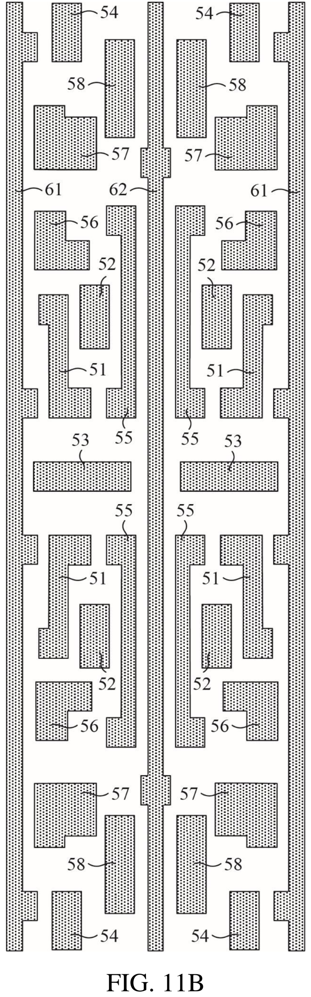

(7) A pattern of a fourth conductive layer is formed. In an exemplary implementation, forming the fourth conductive layer may include: depositing a fourth conductive thin film on the base substrate on which the aforementioned patterns are formed, patterning the fourth conductive thin film using a patterning process to form a fourth conductive layer disposed on the sixth insulating layer, as shown in FIGS. 11A and 11B, FIG. 11B is a schematic planar view of the fourth conductive layer in FIG. 11A. In an exemplary implementation, the fourth conductive layer may be referred to as a first source drain metal (SD1) layer.

In an exemplary implementation, the fourth conductive layer of each circuit unit at least includes a first connection electrode 51, a second connection electrode 52, a third connection electrode 53, a fourth connection electrode 54, a fifth connection electrode 55, a sixth connection electrode 56, a seventh connection electrode 57, an eighth connection electrode 58, a data signal line 61, and a high-frequency signal line 62.

In an exemplary implementation, the first connection electrode 51 may be in a shape of a strip in which a main body portion extends along the second direction Y, a first end of the first connection electrode 51 is connected to the first region of the second active layer (also the second region of the first active layer) through the second via V1, and a second end of the first connection electrode 51 is connected to the first electrode plate 81 through the fifteenth via V15. In an exemplary implementation, since the first electrode plate 81 simultaneously serves as a gate electrode of the third transistor T3, the first connection electrode 51 enables the second electrode of the first transistor T1, the first electrode of the second transistor T2, the gate electrode of the third transistor T3 and the first electrode plate 81 to have a same potential and form the first node N1 of the pixel drive circuit.

In an exemplary implementation, the second connection electrode 52 may be in a shape of a strip in which a main body portion extends along the second direction Y, a first end of the second connection electrode 52 is connected to the second region of the second active layer through the third via V3, and a second end of the second connection electrode 52 is connected to the second region of the third active layer (also the first region of the sixth active layer) through the fourth via V4. In an exemplary implementation, the second connection electrode 52 enables the second electrode of the second transistor T2, the second electrode of the third transistor T3, and the first electrode of the sixth transistor T6 to have a same potential and form the third node N3 of the pixel drive circuit.

In an exemplary implementation, the third connection electrode 53 may be in a shape of a strip in which a main body portion extends along the first direction X, a first end of the third connection electrode 53 is connected to the first region of the first active layer (also the first region of the seventh active layer) through the first via V1, and a second end of the third connection electrode 53 is connected to the initial signal line 45 through the eighteenth via V18. In an exemplary implementation, the third connection electrode 53 enables that the initial signal line 45 simultaneously writes an initial signal to the first electrode of the first transistor T1 and the first electrode of the seventh transistor T7.

In an exemplary implementation, the fourth connection electrode 54 may be in a shape of a strip in which a main body portion extends along the second direction Y, a first end of the fourth connection electrode 54 is connected to the first region of the fifth active layer through the sixth via V6, and a second end of the fourth connection electrode 54 is connected to the first power supply line 36 through a nineteenth via V19. In an exemplary implementation, the fourth connection electrode 54 enables that the first power supply line 36 writes the first power supply signal to the first electrode of the fifth transistor T5.

In an exemplary implementation, the fifth connection electrode 55 may be in a shape of a strip in which a main body portion extends along the second direction Y, a first end of the fifth connection electrode 55 is connected to the second region of the sixth active layer through the seventh via V7, and a second end of the fifth connection electrode 55 is connected to the second region of the seventh active layer through the eighth via V8. In an exemplary implementation, the fifth connection electrode 55 enables that the second electrode of the sixth transistor T6 and the second electrode of the seventh transistor T7 have a same potential and the fourth node N4 of the pixel drive circuit is formed.

In an exemplary implementation, the sixth connection electrode 56 may be in a shape of an "L", a first end of the sixth connection electrode 56 is connected to the second region of the ninth active layer through the twelfth via V12, a second end of the sixth connection electrode 56 is connected to the sixth gate electrode 26 through the sixteenth via V16, and a region between the first end and the second end is connected to the second region of the eighth active layer through the tenth via V10. In an exemplary implementation, the sixth connection electrode 56 realizes the connection of the gate electrode of the sixth transistor T6, the second electrode of the eighth transistor T8, and the second electrode of the ninth transistor T9 to form the fifth node N5 of the pixel drive circuit. In the present disclosure, the sixth connection electrode 56 may be referred to as an interconnection electrode.

In an exemplary implementation, the seventh connection electrode 57 may be in a shape of a block (e.g., a rectangle), a first end of the seventh connection electrode 57 is connected to the second region of the tenth active layer through the fourteenth via V14, a second end of the seventh connection electrode 57 is connected to the eighth gate electrode 28 through the seventeenth via V17, a third end of the seventh connection electrode 57 is connected to the ninth gate electrode 29 through the twenty-first via V21, and a fourth end of the seventh connection electrode 57 is connected to the shelter block 44 through the twenty-second via V22. In an exemplary implementation, since the eighth gate electrode 28 is connected to the second electrode plate 82, the seventh connection electrode 57 realizes the interconnection of the gate electrode of the eighth transistor T8, the gate electrode of the ninth transistor T9 (including the top gate electrode and the bottom gate electrode), the second electrode of the tenth transistor T10 and the second electrode plate 82 of the first capacitor to form the sixth node N6 of the pixel drive circuit.

In an exemplary implementation, the eighth connection electrode 58 may be in a shape of a strip in which a main body portion extends along the second direction Y, a first end of the eighth connection electrode 58 is connected to the first region of the ninth active layer through the eleventh via V11, and a second end of the eighth connection electrode 58 is connected to the light emitting connection block 35-1 through the twentieth via V20. In an exemplary implementation, since the light emitting connection block 35-1 is connected to the light emitting signal line 35, the eighth connection electrode 58 enables that the light emitting signal line 35 may write a light emitting signal to the first electrode of the ninth transistor T9. In the present disclosure, the eighth connection electrode 58 may be referred to as an interconnection electrode.

In an exemplary implementation, the data signal line 61 may be in a shape of a straight line or a polyline in which a main body portion extends along the second direction Y, and the data signal line 61 is connected to the first region of the fourth active layer through the fifth via V5 on the one hand, and connected to the first region of the tenth active layer through the thirteenth via V13 on the other hand, so that the data signal line 61 may write a data signal to the first electrode of the fourth transistor T4 and the first electrode of the tenth transistor T10, respectively.

In an exemplary implementation, the high-frequency signal line 62 may be in a shape of a straight line or a polyline in which a main body portion extends along the second direction Y, and the high-frequency signal line 62 is connected to the first region of the eighth active layer through the ninth via V9, so that the high-frequency signal line 62 may write a high-frequency signal to the first electrode of the eighth transistor T8.

In an exemplary implementation, since the first regions of the eighth active layers of some adjacent circuit units in a unit row are connected to each other, some adjacent circuit units may share one high-frequency signal line 62, and one high-frequency signal line 62 may simultaneously supply a high-frequency signal to pixel drive circuits in two unit columns, thereby reducing one high-frequency signal line and corresponding via, reducing the occupied area of the pixel drive circuit and improving resolution.

In an exemplary implementation, the first connection electrode 51 enables that the first electrode plate 81 has the potential of the first node N1 of the pixel drive circuit, and the third electrode plate 83 has the potential of the first power supply line 36, so that the first electrode plate 81 and the third electrode plate 83 form the storage capacitor of the pixel drive circuit.

In an exemplary implementation, the seventh connection electrode 57 enables that the second electrode plate 82 has the potential of the sixth node N6 of the pixel drive circuit, and the fourth electrode plate 84 has the potential of the second power supply line 37, so that the second electrode plate 82 and the fourth electrode plate 84 form the first capacitor of the pixel drive circuit.

In an exemplary implementation, fourth conductive layers of adjacent unit columns may be mirror symmetrical with respect to a column dividing line. For example, the fourth conductive layers in the N-th unit column and the fourth conductive layers in the (N+1)-th unit column may be mirror symmetrical with respect to a column dividing line. As another example, the fourth conductive layers in the (N+1)-th unit column and the fourth conductive layers in the (N+2)-th unit column may be mirror symmetrical with respect to a column dividing line. For another example, the fourth conductive layers in the (N-1)-th unit column and the fourth conductive layers in the N-th unit column may be mirror symmetrical with respect to a column dividing line.

In an exemplary implementation, fourth conductive layers of adjacent unit rows may be mirror symmetrical with respect to a row dividing line. For example, the fourth conductive layers in the M-th unit row and the fourth conductive layers in the (M+1)-th unit row may be mirror symmetrical with respect to a row dividing line. As another example, the fourth conductive layers in the (M+1)-th unit row and the fourth conductive layers in the (M+2)-th unit row may be mirror symmetrical with respect to a row dividing line. For another example, the fourth conductive layers in the (M-1)-th unit row and the fourth conductive layers in the M-th unit row may be mirror symmetrical with respect to a column dividing line.

In an exemplary implementation, a subsequent preparation process may include: forming a first planarization layer and a seventh insulating layer on which a plurality of vias are provided; forming a fifth conductive layer, which may be referred to as a second source-drain metal (SD2) layer, wherein the fifth conductive layer of each circuit unit may at least include a first pad electrode and a second pad electrode; and forming a second planarization layer and an eighth insulating layer on which a first bonding hole and a second bonding hole are provided, the first bonding hole exposes the first pad electrode, and the second bonding hole exposes the second pad electrode.

So far, the drive circuit layer has been prepared on the base substrate. In a plane parallel to the display substrate, the drive circuit layer may include a plurality of circuit units, each of which may include a pixel drive circuit, and a first scan signal line, a second scan signal line, a third scan signal line, a fourth scan signal line, a light emitting signal line, an initial signal line, a data signal line, a high-frequency signal line, a first power supply line and a second power supply line that are connected to the pixel drive circuit. In a plane perpendicular to the display substrate, the drive circuit layer may include a first insulating layer, a first semiconductor layer, a second insulating layer, a first conductive layer, a third insulating layer, a second conductive layer, a fourth insulating layer, a second semiconductor layer, a fifth insulating layer, a third conductive layer, a sixth insulating layer, a fourth conductive layer, a first planarization layer, a seventh insulating layer, a fifth conductive layer, a second planarization layer, and an eighth insulating layer that are sequentially disposed on the base substrate. The first semiconductor layer may at least include active layers of a plurality of polysilicon transistors, the first conductive layer may at least include a first scan signal line, a light emitting signal line, a first electrode plate of the storage capacitor and a second electrode plate of the first capacitor, the second conductive layer may at least include a third electrode plate of the storage capacitor, a fourth electrode plate of the first capacitor, a second power supply line, an initial signal line and a plurality of shelter lines, the second semiconductor layer may at least include active layers of a plurality of oxide transistors, the third conductive layer may at least include a second scan signal line, a third scan signal line and a fourth scan signal line, the fourth conductive layer may at least include a data signal line, a high-frequency signal line and a plurality of connection electrodes, and the fifth conductive layer may at least include a first pad electrode and a second pad electrode.

In an exemplary implementation, the base substrate may be a flexible base substrate, or a rigid base substrate. The rigid base substrate may include, but is not limited to, one or more of glass and quartz. The flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In an exemplary implementation, the flexible base substrate may include a first flexible material layer, a first inorganic material layer, a semiconductor layer, a second flexible material layer, and a second inorganic material layer which are stacked. Materials of the first flexible material layer and the second flexible material layer may be Polyimide (PI), Polyethylene Terephthalate (PET), or surface treated polymer soft film, etc., and materials of the first inorganic material layer and the second inorganic material layer may be Silicon Nitride (SiNx), Silicon Oxide (SiOx), or the like, for improving water and oxygen resistance of the base substrate. The first inorganic material layer and the second inorganic material layer may also be referred to as barrier layers, and the material of the semiconductor layer may be amorphous silicon (a-si).

In an exemplary implementation, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the aforementioned metals, such as an Aluminum-Neodymium alloy (AlNd) or a Molybdenum-Niobium alloy (MoNb), and may be of a single-layer structure, or a multi-layer composite structure such as Mo/Cu/Mo. The first insulating layer, the second insulating layer, the third insulating layer, the fourth insulating layer, the fifth insulating layer, the sixth insulating layer, the seventh insulating layer and the eighth insulating layer may be any one or more of silicon oxide (SiOx), silicon nitride (SiNx) and silicon oxynitride (SiON), and may be single-layer, multi-layer, or composite layer. The first planarization layer and the second planarization layer may be made of an organic material, such as resin.

In an exemplary implementation, pixel drive circuits in two adjacent circuit units in a unit row may be substantially mirror symmetrical with respect to a column dividing line. For example, the pixel drive circuits in the N-th unit column and the pixel drive circuits in the (N+1)-th unit column may be mirror symmetrical with respect to a column dividing line.

In an exemplary implementation, pixel drive circuits in two adjacent circuit units in a unit column may be substantially mirror symmetrical with respect to a row dividing line. For example, the pixel drive circuits in the M-th unit row and the pixel drive circuits in the (M+1)-th unit row may be mirror symmetrical with respect to a row dividing line.

In an exemplary implementation, after the drive circuit layer is prepared, a light emitting structure layer is prepared on the drive circuit layer. In an exemplary implementation, the preparation process of the light emitting structure layer may include: firstly adding a bonding material (such as solder paste) into a plurality of first bonding holes and a plurality of second bonding holes using a glue dispenser, bonding and connecting first electrodes of a plurality of light emitting diodes with the first pad electrode through the first bonding holes through the transfer and die bonding process, and bonding and connecting second electrodes of the plurality of light emitting diodes with the second pad electrode through the second bonding holes to complete the connection between the light emitting diodes and the corresponding pixel drive circuits. Subsequently, a covering thin film is coated on the base substrate on which the aforementioned structures is formed, to form a covering layer that covers the plurality of light emitting diodes. In an exemplary implementation, the plurality of light emitting diodes and the covering layer may form a light emitting structure layer.

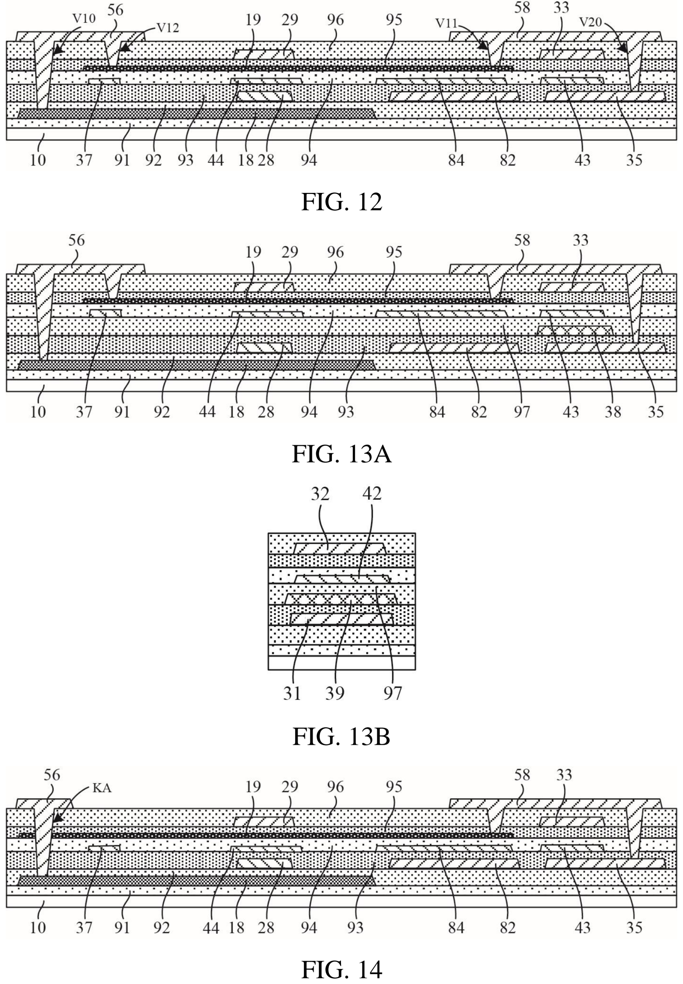

FIG. 12 is a sectional view taken in an A-A direction in FIG. 11A, and illustrates a film layer structure in a region where the eighth transistor T8 and the ninth transistor T9 are located. As shown in FIG. 12, in a plane perpendicular to the display substrate, the display substrate may include:
a first insulating layer 91 arranged on a base substrate 10;
a first semiconductor layer disposed on a side of the first insulating layer 91 away from the base substrate 10, wherein the first semiconductor layer may at least include an eighth active layer 18 of an eighth transistor T8;
a second insulating layer 92 disposed on a side of the first semiconductor layer away from the base substrate 10;
a first conductive layer (GATE1) disposed on a side of the second insulating layer 92 away from the base substrate 10, wherein the first conductive layer may at least include an eighth gate electrode 28 of the eighth transistor T8, a light emitting signal line 35, and a second electrode plate 82;
a third insulating layer 93 disposed on a side of the first conductive layer away from the base substrate 10;
a second conductive layer (GATE2) disposed on a side of the third insulating layer 93 away from the base substrate 10, wherein the second conductive layer may at least include a second power supply line 37, a third shelter line 43, a shelter block 44, and a fourth electrode plate 84, an orthographic projection of the fourth electrode plate 84 on the base substrate overlaps at least partially an orthographic projection of the second electrode plate 82 on the base substrate, the second electrode plate 82 and the fourth electrode plate 84 form a first capacitor of the pixel drive circuit;
a fourth insulating layer 94 disposed on a side of the second conductive layer away from the base substrate 10;
a second semiconductor layer disposed on a side of the fourth insulating layer 94 away from the base substrate 10, wherein the second semiconductor layer may at least include a ninth active layer 19 of the ninth transistor T9, an orthographic projection of the ninth active layer 19 on the base substrate overlaps at least partially an orthographic projection of the eighth active layer 18 on the base substrate;
a fifth insulating layer 95 disposed on a side of the second semiconductor layer away from the base substrate 10;
a third conductive layer (GATE3) disposed on a side of the fifth insulating layer 95 away from the base substrate 10, wherein the third conductive layer may at least include a ninth gate electrode 29 of a ninth transistor T9 and a third scan signal line 33, an orthographic projection of the ninth gate electrode 29 on the base substrate overlaps at least partially an orthographic projection of the eighth gate electrode 28 on the base substrate, an orthographic projection of the third scan signal line 33 on the base substrate overlaps at least partially an orthographic projection of the light emitting signal line 35 on the base substrate;
a sixth insulating layer 96 disposed on a side of the third conductive layer away from the base substrate 10;
a fourth conductive layer (SD1) disposed on a side of the sixth insulating layer 96 away from the base substrate 10, wherein the fourth conductive layer may at least include a sixth connection electrode 56 and an eighth connection electrode 58 as interconnection electrodes. One end of the sixth connection electrode 56 is connected to the eighth active layer 18 through a tenth via V10, and the other end of the sixth connection electrode 56 is connected to the ninth active layer 19 through a twelfth via V12 to form a fifth node of the interconnection structure. One end of the eighth connection electrode 58 is connected to the ninth active layer through an eleventh via V11, and the other end of the eighth connection electrode 58 is connected to the light emitting signal line 35 through a twentieth via V20, so that the light emitting signal line 35 writes a light emitting signal to the ninth transistor T9.

At present, due to the complexity of the pixel drive circuit of the Micro LED display/Mini LED display, a larger number of transistors occupy a large area, which limits the improvement of the resolution (Pixels Per Inch, or PPI). The display substrate provided by the exemplary embodiment of the present disclosure effectively reduces the occupied area of the pixel drive circuit and effectively improves the resolution by arranging an eighth transistor and a ninth transistor in a stacked transistor structure, arranging a first scan signal line and a second scan signal line in a stacked signal line structure, and arranging a third scan signal line and a light emitting signal line in a stacked signal line structure. In the present disclosure, by arranging the ninth transistor on a side of the eighth transistor away from the base substrate, not only the gate electrodes of the two transistors are overlapped to save the area of the gate electrodes, but also the connection and sharing of the two transistors are easy, to reduce the area of the connection electrodes. Under the condition of the same pixel drive circuit, the display substrate provided by the present disclosure effectively improves the resolution, and compared with the existing structure of about 240 PPI, the PPI of the display substrate of the present disclosure can be improved to about 326 PPI.

In the exemplary embodiment of the present disclosure, by adopting the horizontal mirroring and vertical mirroring structures of pixel drive circuits, two adjacent unit rows share an initial signal line, and two adjacent unit columns share a high-frequency signal line which not only reduces the quantity of signal lines, but also reduces the corresponding via connection structures, effectively reduces the occupied area of the pixel drive circuit, and improves the resolution as much as possible.

The preparation process in the present disclosure can be compatible well with an existing preparation process, is simple in process implementation, is easy to implement, and has a high production efficiency, a low production cost, and a high yield.

It should be noted that the structure and preparation process therefor shown in an exemplary embodiment of the present disclosure are merely illustrative, and a corresponding structure may be changed and patterning processes may be increased or decreased according to actual needs. For example, the fourth transistor and the second transistor may be provided as a stacked transistor structure, and the second transistor is provided on a side of the fourth transistor away from the base substrate. As another example, the fifth transistor and the tenth transistor may be provided as a stacked transistor structure, and the tenth transistor is provided on a side of the fifth transistor away from the base substrate, which is not specifically limited in the embodiment of the present disclosure.

FIG. 13A and FIG. 13B are schematic diagrams of a structure of another display substrate according to an exemplary embodiment of the present disclosure, FIG. 13A is a sectional view in the A-A direction in FIG. 11A, illustrating a film layer structure in a region where the eighth transistor T8 and the ninth transistor T9 are located, and FIG. 13B is a sectional view in the B-B direction in FIG. 11A, illustrating a film layer structure in a region where the first scan signal line 31 and the second scan signal line 32 are located. The main structure of the display substrate of the present embodiment is substantially the same as that of the embodiment shown in FIG. 12, except that the display substrate of the present embodiment further includes a shielding layer and a shielding insulating layer.

As shown in FIGS. 13A and 13B, in a plane perpendicular to the display substrate, the display substrate may include a first insulating layer 91, a first semiconductor layer, a second insulating layer 92, a first conductive layer, a third insulating layer 93, a shielding layer, a shielding insulating layer 97, a second conductive layer, a fourth insulating layer 94, a second semiconductor layer, a fifth insulating layer 95, a third conductive layer, a sixth insulating layer 96 and a fourth conductive layer arranged sequentially on the base substrate. The structures of the first semiconductor layer, the first conductive layer, the second conductive layer, the second semiconductor layer, the third conductive layer and the fourth conductive layer are substantially the same as those of the foregoing embodiments.

In an exemplary implementation, the shielding layer may be disposed between the first conductive layer and the second conductive layer.

In an exemplary implementation, the shielding layer may be disposed on a side of the third insulating layer 93 away from the base substrate 10, and the shielding layer may at least include a first shielding line 38 and a second shielding line 39. The shielding insulating layer 97 may be disposed on a side of the shielding layer away from the base substrate 10, and the second conductive layer may be disposed on a side of the shielding insulating layer away from the base substrate 10.

As shown in FIG. 13A, in an exemplary implementation, in a direction perpendicular to the display substrate, the first shielding line 38 may be disposed between the third scan signal line 33 and the light emitting signal line 35, the first shielding line 38 may be in a shape of a straight line or a polyline in which a main body portion extends along the first direction X, the position of the first shielding line 38 may correspond to the positions of the light emitting signal line 35 and the third scan signal line 33, an orthographic projection of the first shielding line 38 on the base substrate at least partially overlaps an orthographic projection of the light emitting signal line 35 on the base substrate, and an orthographic projection of the first shielding line 38 on the base substrate at least partially overlaps an orthographic projection of the third scan signal line 33 on the base substrate.

In an exemplary implementation, an orthographic projection of the light emitting signal line 35 (excluding the portion of the light emitting connection block) on the base substrate may be within a range of an orthographic projection of the first shielding line 38 on the base substrate, and an orthographic projection of the third scan signal line 33 on the base substrate may be within a range of an orthographic projection of the first shielding line 38 on the base substrate.

As shown in FIG. 13B, in an exemplary implementation, the second shielding line 39 may be disposed between the first scan signal line 31 and the second scan signal line 32 in a direction perpendicular to the display substrate, the second shielding line 39 may be in a shape of a straight line or a polyline in which a main body portion extends along the first direction X, the position of the second shielding line 39 may correspond to the positions of the first scan signal line 31 and the second scan signal line 32, an orthographic projection of the second shielding line 39 on the base substrate at least partially overlaps an orthographic projection of the first scan signal line 31 on the base substrate, and an orthographic projection of the second shielding line 39 on the base substrate at least partially overlaps an orthographic projection of the second scan signal line 32 on the base substrate.

In an exemplary implementation, an orthographic projection of the first scan signal line 31 on the base substrate may be within a range of an orthographic projection of the second shielding line 39 on the base substrate, and an orthographic projection of the second scan signal line 32 on the base substrate may be within a range of an orthographic projection of the second shielding line 39 on the base substrate.

In an exemplary implementation, the first shielding line and the second shielding line 39 may be connected to the first power supply line, or may be connected to the second power supply line, or may be connected to a ground signal, which is not limited here in the present disclosure.

In an exemplary implementation, the shielding layer may also be provided as other shielding structures, which is not limited here in the present disclosure.

In an exemplary implementation, the preparation process of the display substrate of the present embodiment may include the following acts: sequentially forming the first insulating layer 91, the first semiconductor layer, the second insulating layer 92, and the first conductive layer (GATE1), the preparation process of which is substantially the same as that of the foregoing embodiments; subsequently, depositing a third insulating thin film and a shielding thin film sequentially on the base substrate on which the above-mentioned patterns are formed, patterning the shielding thin film by a patterning process to form a third insulating layer covering the first conductive layer, and a pattern of a shielding layer disposed on the third insulating layer; then, forming a shielding insulating layer 97, a second conductive layer, a fourth insulating layer 94, a second semiconductor layer, a fifth insulating layer 95, a third conductive layer, a sixth insulating layer 96, and a fourth conductive layer sequentially, of which the preparation process is substantially the same as that of the foregoing embodiments.

The display substrate provided in the present embodiment not only has the technical effects of the foregoing embodiments, i.e., effectively reduces the occupied area of the pixel drive circuit and is beneficial to improving the resolution, but also can improve the working performance of the pixel drive circuit and improve the display quality by providing a shielding layer. By arranging the first shielding line between the light emitting signal line and the third scan signal line which are stacked, the present embodiment can effectively avoid the coupling between the light emitting signal line and the third scan signal line, and reduce the mutual influence between the light emitting signal line and the third scan signal line. By arranging the second shielding line between the first scan signal line and the second scan signal line which are stacked, the present embodiment can effectively avoid the coupling between the first scan signal line and the second scan signal line, and reduce the mutual influence between the first scan signal line and the second scan signal line. The display substrate of the present embodiment can reduce the occupied area of the pixel drive circuit, improve the resolution, while ensuring the working performance of the pixel drive circuit and the display quality.

FIG. 14 is a schematic diagram of a structure of yet another display substrate according to an exemplary embodiment of the present disclosure, illustrating a film layer structure of a region where an eighth transistor T8 and a ninth transistor T9 are located. The main structure of the display substrate of the present embodiment is substantially the same as that of the embodiment shown in FIG. 12, except that the sixth connection electrode 56 as an interconnection electrode in the present embodiment is simultaneously connected to an eighth active layer 18 and a ninth active layer 19 through a lap hole.

As shown in FIG. 14, in a plane perpendicular to the display substrate, the display substrate may include a first insulating layer 91, a first semiconductor layer, a second insulating layer 92, a first conductive layer, a third insulating layer 93, a second conductive layer, a fourth insulating layer 94, a second semiconductor layer, a fifth insulating layer 95, a third conductive layer, a sixth insulating layer 96, and a fourth conductive layer arranged sequentially on the base substrate, and the main structures of the above-mentioned film layers are substantially the same as those of the foregoing embodiment.

In an exemplary implementation, the sixth connection electrode 56, which serves as an interconnection electrode, on the one hand, is lapped with a first surface of the eighth active layer 18 through a lap hole KA, and on the other hand, is lapped with a second surface of the ninth active layer 19 through a lap hole KA, the first surface is a surface of the eighth active layer 18 parallel to the base substrate 10, and the second surface is a surface of the ninth active layer 19 intersecting the base substrate 10.

In an exemplary implementation, an included angle between the second surface of the ninth active layer 19 and the plane of the base substrate may be 50 degrees to 70 degrees.

In an exemplary implementation, the lap hole KA may be provided in a plurality of insulating layers and the second semiconductor layer, the lap hole KA may penetrate the second insulating layer 92, the third insulating layer 93, the fourth insulating layer 94, the second semiconductor layer, the fifth insulating layer 95 and the sixth insulating layer 96 that are stacked, and the lap hole KA exposes the first surface of the eighth active layer 18 on the one hand, and exposes the second surface of the ninth active layer 19 on the other hand.

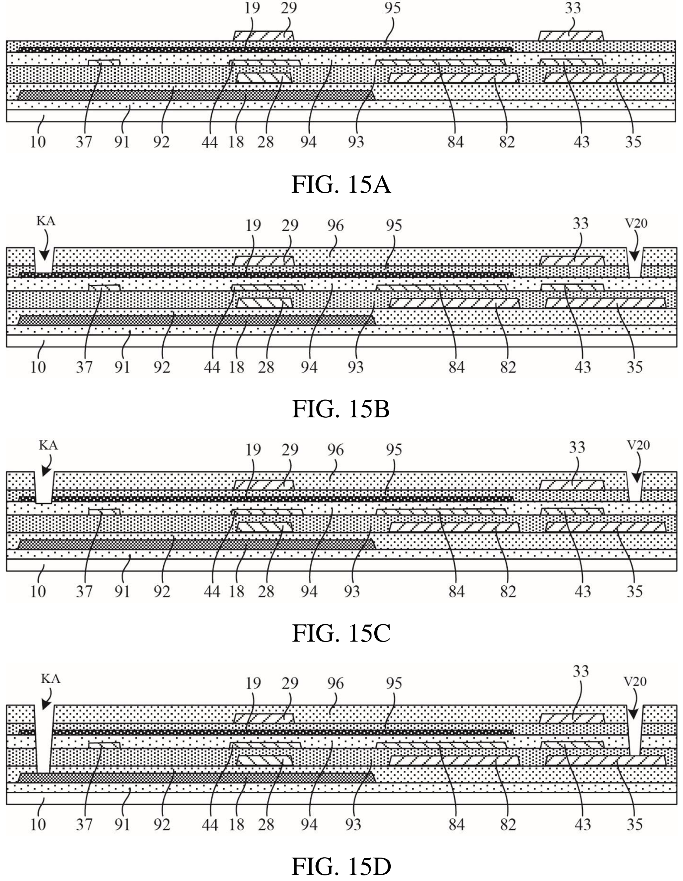

In an exemplary implementation, the process of preparing the display substrate according to the present embodiment may include the following acts.
(11) A first insulating layer 91, a first semiconductor layer, a second insulating layer 92, a first conductive layer (GATE1), a third insulating layer 93, a second conductive layer (GATE2), a fourth insulating layer 94, a second semiconductor layer, a fifth insulating layer 95, and a third conductive layer (GATE3) are formed sequentially, the preparation process of which is substantially the same as that of the foregoing embodiment. The first semiconductor layer may at least include an eighth active layer 18, the first conductive layer may at least include an eighth gate electrode 28, a light emitting signal line 35 and a second electrode plate 82, the second conductive layer may at least include a second power supply line 37, a third shelter line 43, a shelter block 44 and a fourth electrode plate 84, the second semiconductor layer may at least include a ninth active layer 19, and the third conductive layer may at least include a ninth gate electrode 29 and a third scan signal line 33, as shown in FIG. 15A.
(12) A sixth insulating thin film is deposited, and the sixth insulating thin film is patterned by a patterning process to form a sixth insulating layer 96 covering the third conductive layer. At least a lap hole KA and a twentieth via V20 are formed on the sixth insulating layer 96. The sixth insulating layer 96 and the fifth insulating layer 95 in the lap hole KA and the twentieth via V20 are etched away. The lap hole KA exposes a surface of the ninth active layer 19 away from the base substrate, and the twentieth via V20 exposes a surface of the fourth insulating layer 94 away from the base substrate, as shown in FIG. 15B.

In an exemplary implementation, the etching of the lap hole in this patterning process may adopt an Inductively Coupled Plasma (ICP) dry etching mode.

(13) The display substrate is placed in a Buffered Oxide Etch (BOE) liquid, which etches the ninth active layer 19 exposed by the lap hole KA, and removes the ninth active layer 19 in the lap hole KA, so that the lap hole KA exposes the second surface of the ninth active layer 19 and a surface of the fourth insulating layer 94 away from the base substrate. Since the buffered oxide etch liquid cannot etch an inorganic layer, the twentieth via V20 does not change, as shown in FIG. 15C.

In an exemplary implementation, the lap hole KA enables the ninth active layer 19 to form with an annular lap sidewall, and an included angle between the lap sidewall and the plane of the base substrate may be about 50 degrees to 70 degrees.

By etching (wet etching) the ninth active layer 19 with the oxide etch liquid, the present disclosure can improve the surface quality of the second surface, so that the lap resistance of a subsequently formed sixth connection electrode with the ninth active layer 19 contacted in side and the lap resistance of the subsequently formed sixth connection electrode with the ninth active layer 19 contacted in front have the same or similar resistance value.

(14) The display substrate after wet etching is subjected to ICP dry etching, to remove the fourth insulating layer 94, the third insulating layer 93, and the second insulating layer 92 in the lap hole KA, and remove the fourth insulating layer 94 and the third insulating layer 93 in the twentieth via V20, so that the lap hole KA exposes a surface (the first surface) of the eighth active layer 18 away from the base substrate, and the twentieth via V20 exposes a surface of the light emitting signal line 35 away from the base substrate, as shown in FIG. 15D.

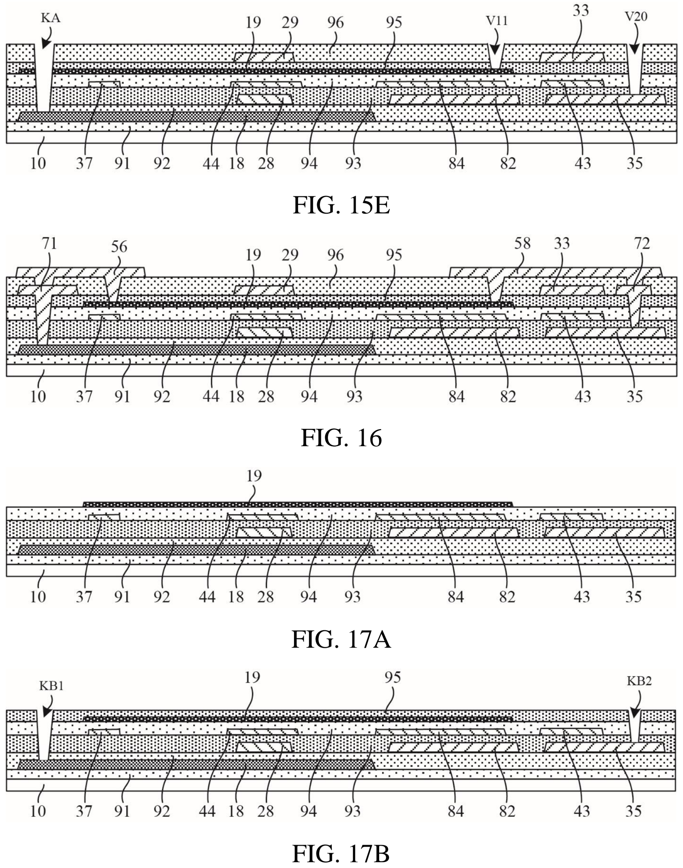

(15) The sixth insulating layer 96 and the fifth insulating layer 95 are patterned by a patterning process to form an eleventh via V11, and the sixth insulating layer 96 and the fifth insulating layer 95 in the eleventh via V11 are etched away to expose a surface of the ninth active layer 19 away from the base substrate, as shown in FIG. 15E.

(16) A fourth conductive thin film is deposited, the fourth conductive thin film is patterned by a patterning process, to form a fourth conductive layer (SD1) on the sixth insulating layer 96. The fourth conductive layer may at least include a sixth connection electrode 56 and an eighth connection electrode 58 as interconnection electrodes. The sixth connection electrode 56 is lapped with the first surface of the eighth active layer 18 on the one hand and the second surface of the ninth active layer 19 on the other hand through the lap hole KA, achieving connections to both the eighth active layer 18 and the ninth active layer 19 through one lap hole at the same time, to form a fifth node of the interconnection structure. One end of the eighth connection electrode 58 is connected to the ninth active layer 19 through the eleventh via V11, and the other end of the eighth connection electrode 58 is connected to the light emitting signal line 35 through the twentieth via V20, so that the light emitting signal line 35 writes a light emitting signal to the ninth transistor T9, as shown in FIG. 14.

The preparation process shown in the present embodiment is only an exemplary illustration, and the corresponding structure may be changed according to the actual connection relationship. For example, a via exposing a surface of the third conductive layer may also be formed simultaneously in act (15), which is not specifically limited here in the present disclosure.

Based on current process capabilities, the size of the via is about 2.5 µm. Considering the exposure alignment accuracy, etching deviation and non-uniformity due to etching, the outer side of each via needs to be increased by about 1.5 µm of wrapping. Therefore, for each additional via in a circuit unit, the circuit unit needs to be increased by about 5.5 µm (2.5 µm + 2*1.5 µm), which greatly affects the improvement of resolution.

In the display substrate provided by the embodiment of the present disclosure, the fourth conductive layer may be connected with an oxide active layer and a polysilicon active layer at the same time using a lap hole, which can effectively reduce the quantity of vias, effectively reduce the occupied space of the pixel drive circuit, and is beneficial to high resolution. In the present disclosure, by providing a lap hole which simultaneously exposes a side surface of the ninth active layer which is oxide and a front surface of the eighth active layer wich is polysilicon, the interconnection electrode is lapped with the side surface of the eighth active layer through the lap hole on the one hand, and with the front surface of the ninth active layer through the lap hole on the other hand, a two-hole interconnection structure is optimized as a single-hole interconnection structure, which not only reduces the quantity of vias, but also reduces the complexity of the punching process and can effectively improve the yield.

In an exemplary implementation, a plurality of two-hole interconnection structures or three-hole interconnection structures exist in the circuit unit. For example, the second connection electrode in the structure of FIG. 4 is the two-hole interconnection structure, wherein the second connection electrode is connected to the second region of the second active layer through one via and connected to the second region of the third active layer through another via. As another example, the seventh connection electrode in the structure of FIG. 4 is the three-hole interconnection structure, wherein the seventh connection electrode is connected to the second region of the tenth active layer through one via, connected to the eighth gate electrode through another via, and connected to the ninth gate electrode through yet another via. These two-hole or three-hole interconnection structures not only bring great pressure on the layout space, but also greatly affect the yield due to the complexity of the punching process. The single-hole interconnection structure provided by the embodiment of the disclosure may be adaptively applied to the above interconnection structures, and the two-hole interconnection structure is optimized as a single-hole interconnection structure, and the three-hole interconnection structure is optimized as a two-hole interconnection structure or a single-hole interconnection structure, which can not only greatly save the layout space in a complex layout, improve the resolution as much as possible, but also can reduce the complexity of the punching process, and effectively improve the yield of product.

In an exemplary implementation, the single-hole interconnection structure provided by the embodiment of the present disclosure may be applied to a scheme of a shielding layer provided shown in FIG. 13, which will not be repeated here.

FIG. 16 is a schematic diagram of a structure of still yet another display substrate according to an exemplary embodiment of the present disclosure, illustrating a film layer structure of a region where the eighth transistor T8 and the ninth transistor T9 are located. The main body structure of the display substrate of the present embodiment is substantially the same as that of the embodiment shown in FIG. 12, except that the third conductive layer (GATE3) is provided as a transfer structure layer in the present embodiment.

As shown in FIG. 16, in a plane perpendicular to the display substrate, the display substrate may include a first insulating layer 91, a first semiconductor layer, a second insulating layer 92, a first conductive layer, a third insulating layer 93, a second conductive layer, a fourth insulating layer 94, a second semiconductor layer, a fifth insulating layer 95, a third conductive layer, a sixth insulating layer 96, and a fourth conductive layer that are sequentially disposed on the base substrate.

In an exemplary implementation, the third conductive layer is further provided with a first transfer electrode 71 and a second transfer electrode 72 as transfer structures, the first transfer electrode 71 is connected to the eighth active layer 18 through a first transfer hole, and the second transfer electrode 72 is connected to the light emitting signal line 35 through a second transfer hole. The fourth conductive layer may at least include a sixth connection electrode 56 and an eighth connection electrode 58, wherein one end of the sixth connection electrode 56 is connected to the ninth active layer 19 through a via, the other end of the sixth connection electrode 56 is connected to the first transfer electrode 71 through another via, one end of the eighth connection electrode 58 is connected to the ninth active layer through a via, and the other end of the eighth connection electrode 58 is connected to the second transfer electrode 72 through another via.

In an exemplary implementation, the process of preparing the display substrate according to the present embodiment may include the following acts.
(21) The first insulating layer 91, the first semiconductor layer, the second insulating layer 92, the first conductive layer (GATE1), the third insulating layer 93, the second conductive layer (GATE2), the fourth insulating layer 94, and the second semiconductor layer are formed sequentially, the preparation process of which is substantially the same as that of the foregoing embodiment. The first semiconductor layer may at least include an eighth active layer 18, the first conductive layer may at least include an eighth gate electrode 28, a light emitting signal line 35, and a second electrode plate 82, the second conductive layer may at least include a second power supply line 37, a third shelter line 43, a shelter block 44, and a fourth electrode plate 84, and the second semiconductor layer may at least include a ninth active layer 19, as shown in FIG. 17A.
(22) A fifth insulating thin film is deposited, and the fifth insulating thin film is patterned by a patterning process to form a fifth insulating layer 95 covering the second semiconductor layer, and a first transfer hole KB1 and a second transfer hole KB2 are formed on the fifth insulating layer 95. The fifth insulating layer 95, the fourth insulating layer 94, the third insulating layer 93, and the second insulating layer 92 in the first transfer hole KB1 are removed to expose a surface of the eighth active layer 18. The fifth insulating layer 95, the fourth insulating layer 94, and the third insulating layer 93 in the second transfer hole KB2 are removed to expose a surface of the light emitting signal line 35, as shown in FIG. 17B.

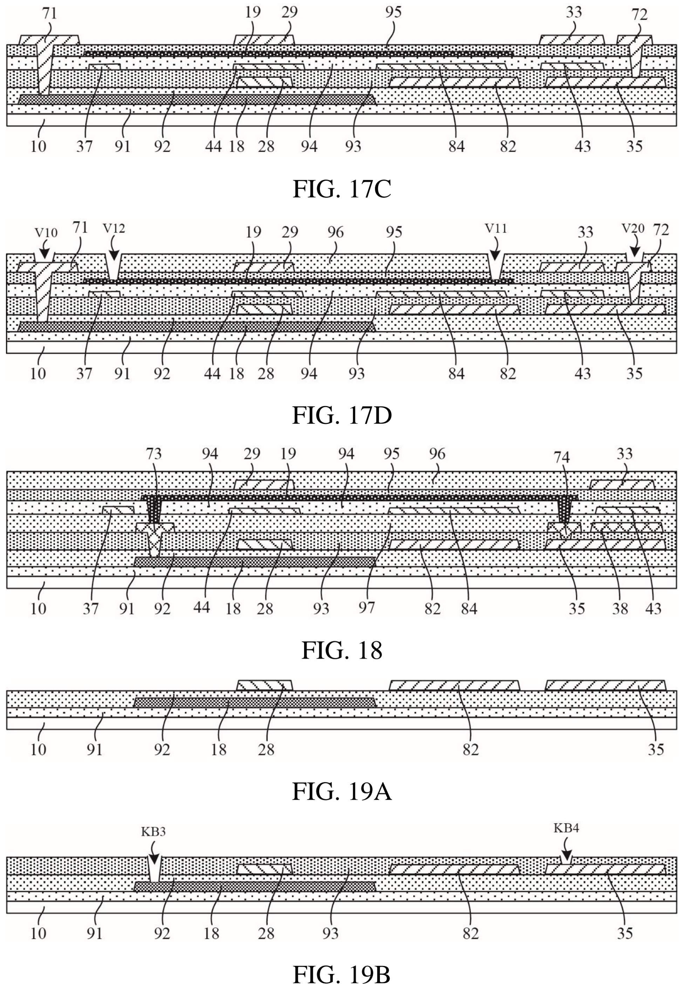

In an exemplary implementation, in the present patterning process a transfer hole may not be provided in a region where the second semiconductor layer is located, so as to avoid the connection between a subsequently formed third conductive layer and the second semiconductor layer.
(23) A third conductive thin film is deposited, the third conductive thin film is patterned by a patterning process to form a third conductive layer (GATE3) on the fifth insulating layer 95. The third conductive layer may at least include a ninth gate electrode 29, a third scan signal line 33, a first transfer electrode 71 and a second transfer electrode 72. The first transfer electrode 71 is connected to the eighth active layer 18 through the first transfer hole KB1, and the second transfer electrode 72 is connected to the light emitting signal line 35 through the second transfer hole KB2, as shown in FIG. 17C.
(24) A sixth insulating thin film is deposited, and the sixth insulating thin film is patterned by a patterning process to form a sixth insulating layer 96 covering the third conductive layer. The sixth insulating layer 96 is provided with a tenth via V10, an eleventh via V11, a twelfth via V12, and a twentieth via V20. The sixth insulating thin film in the tenth via V10 is removed to expose a surface of the first transfer electrode 71. The sixth insulating thin film and the fifth insulating thin film in the eleventh via V11 are removed to expose a surface of the ninth active layer 19. The sixth insulating thin film and the fifth insulating thin film in the twelfth via V12 are removed to expose a surface of the ninth active layer 19. The sixth insulating thin film in the twentieth via V20 is removed to expose a surface of the second transfer electrode 72, as shown in FIG. 17D.

In an exemplary implementation, since all the film layers below the second semiconductor layer have been transferred out through a plurality of transfer electrodes in the third conductive layer, this patterning process requires only one MASK, and the formed vias only need to expose the second semiconductor layer and the third conductive layer. Compared with the process having ILD-L MASK and ILD-O MASK in the embodiment shown in FIG. 4, there is no additional MASK in the present embodiment.

(25) A fourth conductive thin film is deposited, the fourth conductive thin film is patterned by a patterning process to form a fourth conductive layer (SD1) on the sixth insulating layer 96, the fourth conductive layer may at least include a sixth connection electrode 56 and an eighth connection electrode 58. The sixth connection electrode 56 is connected to the first transfer electrode 71 through the tenth via V10 on the one hand, and connected to the ninth active layer 19 through the twelfth via V12 on the other hand. Since the first transfer electrode 71 is connected to the eighth active layer 18 through the via, it is achieved that the sixth connection electrode 56 is connected to the eighth active layer 18 and the ninth active layer 19 at the same time to form a fifth node of the interconnection structure. The eighth connection electrode 58 is connected to the second transfer electrode 72 through the twentieth via V20 on the one hand, and connected to the ninth active layer 19 through the eleventh via V11 on the other hand. Since the second transfer electrode 72 is connected to the light emitting signal line 35, it is achieved that the eighth connection electrode 58 is connected to the light emitting signal line 35 and the ninth active layer 19 at the same time, and the light emitting signal line 35 may write a light emitting signal to the ninth transistor T9, as shown in FIG. 16.

The preparation process shown in the present embodiment is only an exemplary illustration, and the corresponding structure may be changed according to the actual connection relationship. For example, a connection hole exposing a surface of the second conductive layer may also be formed simultaneously in act (22). As another example, in act (24), a connection hole exposing a surface of the third conductive layer may also be formed simultaneously. The present disclosure is not specifically limited thereto.

The display substrate provided by the embodiment of the disclosure utilizes the third conductive layer, which has a relatively generous layout space, as a transfer structure layer, which not only can effectively alleviate the layout pressure of a plurality of connection electrodes in the fourth conductive layer, be beneficial to the optimization of the layout structure, effectively improve the resolution, but also can reduce the depth of vias, reduce the process difficulty, improve the connection reliability and effectively improve the yield of product.

In an exemplary implementation, a plurality of deep hole connection structures exit in the circuit unit. For example, in the structure of FIG. 4, a plurality of vias exposing the first semiconductor layer and a plurality of vias exposing the first conductive layer are deeper vias. These deep-hole connection structures not only bring a lot of pressure on the arrangement of the plurality of connection electrodes in the fourth conductive layer, but also greatly affect the yield due to the complexity of the deep-hole preparation process and connection. The use of the third conductive layer as an transfer structure layer provided by the embodiment of the disclosure can be adaptively applied to the deep-hole connection structures, which not only can effectively alleviate the layout pressure of the plurality of connection electrodes in the fourth conductive layer, be beneficial to the optimization of the layout structure, effectively improve the resolution, but also can reduce the depth of vias, reduce the process difficulty, improve the connection reliability and effectively improve the yield of product.

In an exemplary implementation, the use of the third conductive layer as the transfer structure layer provided by the embodiment of the present disclosure may be applied to the scheme of the shielding layer provided as shown in FIG. 13, which will not be repeated here.

FIG. 18 is a schematic diagram of a structure of also still yet another display substrate according to an exemplary embodiment of the present disclosure, illustrating a film layer structure of a region where the eighth transistor T8 and the ninth transistor T9 are located. The main structure of the display substrate of the present embodiment is substantially the same as that of the embodiment shown in FIG. 13, except that the shielding layer is set as the transfer structure layer in the present embodiment, and the second semiconductor layer is connected with the transfer structure layer through vias.

As shown in FIG. 18, in a plane perpendicular to the display substrate, the display substrate may include a first insulating layer 91, a first semiconductor layer, a second insulating layer 92, a first conductive layer, a third insulating layer 93, a shielding layer, a shielding insulating layer 97, a second conductive layer, a fourth insulating layer 94, a second semiconductor layer, a fifth insulating layer 95, a third conductive layer, a sixth insulating layer 96, and a fourth conductive layer that are sequentially disposed on the base substrate.

In an exemplary implementation, the shielding layer is further provided with a third transfer electrode 73 and a fourth transfer electrode 74 as transfer structures. The third transfer electrode 73 is connected to the eighth active layer 18 through a third transfer hole, and the fourth transfer electrode 74 is connected to the light emitting signal line 35 through a fourth transfer hole. The second semiconductor layer may at least include a ninth active layer 19, which is connected to the third transfer electrode 73 through a fifth transfer hole on the one hand, and connected to the fourth transfer electrode 74 through a sixth transfer hole on the other hand.

In an exemplary implementation, the process of preparing the display substrate according to the present embodiment may include the following acts.
(31) The first insulating layer 91, the first semiconductor layer, the second insulating layer 92, and the first conductive layer (GATE1) are formed sequentially, the preparation process of which is substantially the same as that of the foregoing embodiment. The first semiconductor layer may at least include an eighth active layer 18, and the first conductive layer may at least include an eighth gate electrode 28, a light emitting signal line 35 and a second electrode plate 82, as shown in FIG. 19A.
(32) A third insulating thin film is deposited, and the third insulating thin film is patterned by a patterning process to form a third insulating layer 93 covering the first conductive layer, and a third transfer hole KB3 and a fourth transfer hole KB4 are formed on the third insulating layer 93. The third insulating layer 93 and the second insulating layer 92 in the third transfer hole KB3 are removed to expose a surface of the eighth active layer 18. The third insulating layer 93 in the fourth transfer hole KB4 is removed to expose a surface of the light emitting signal line 35, as shown in FIG. 19B.

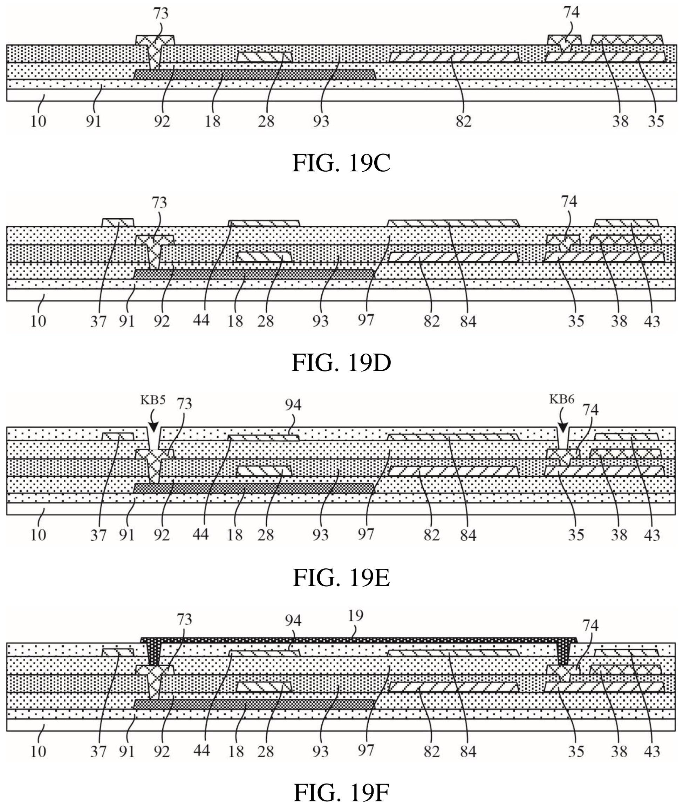

In an exemplary implementation, after the third and fourth transfer holes KB3 and KB4 are formed, the transfer holes may be cleaned with buffered oxide etch liquid to improve the contact quality of the first semiconductor layer and the transfer electrode.
(33) A shielding thin film is deposited, the shielding thin film is patterned by a patterning process to form a shielding layer on the third insulating layer 93. The shielding layer may at least include a third transfer electrode 73, a fourth transfer electrode 74, a first shielding line 38, and a second shielding line (not shown), and the shapes, positions, and structures of the first and second shielding lines may be substantially the same as those of the foregoing embodiments. In an exemplary implementation, the third transfer electrode 73 is connected to the eighth active layer 18 through the third transfer hole KB3, and the fourth transfer electrode 74 is connected to the light emitting signal line 35 through the fourth transfer hole KB4, as shown in FIG. 19C.
(34) A shielding insulating layer 97 covering the shielding layer, and a second conductive layer (GATE2) provided on the shielding insulating layer 97 are formed sequentially, and the second conductive layer may at least include a second power supply line 37, a third shelter line 43, a shelter block 44, and a fourth electrode plate 84, as shown in FIG. 19D.
(35) A fourth insulating thin film is deposited, and the fourth insulating thin film is patterned by a patterning process to form a fourth insulating layer 94 covering the first conductive layer, and a fifth transfer hole KB5 and a sixth transfer hole KB6 are formed in the fourth insulating layer 94. The fourth insulating layer 94 and the shielding insulating layer 97 in the fifth transfer hole KB5 are removed to expose a surface of the third transfer electrode 73, and the fourth insulating layer 94 and the shielding insulating layer 97 in the sixth transfer hole KB6 are removed to expose a surface of the fourth transfer electrode 74, as shown in FIG. 19E.
(36) A second semiconductor thin film is deposited, the second semiconductor thin film is patterned by a patterning process to form a second semiconductor layer on the fourth insulating layer 94. The second semiconductor layer may at least include a ninth active layer 19 connected to the third transfer electrode 73 through the fifth transfer hole KB5 on the one hand, and connected to the fourth transfer electrode 74 through the sixth transfer hole KB6 on the other hand, as shown in FIG. 19F.

In an exemplary implementation, since the third transfer electrode 73 is connected to the eighth active layer 18 through a via, the connection of the ninth active layer 19 and the eighth active layer 18 is achieved to form a fifth node of the interconnection structure. Since the fourth transfer electrode 74 is connected to the light emitting signal line 35, the connection of the light emitting signal line 35 and the ninth active layer 19 is achieved, and the light emitting signal line 35 may write a light emitting signal to the ninth transistor T9.

(37) A fifth insulating layer 95 covering the second semiconductor layer, a third conductive layer (GATE3) disposed on the fifth insulating layer 95, a sixth insulating layer 96 covering the third conductive layer, and a fourth conductive layer disposed on the sixth insulating layer 96 are formed sequentially, the third conductive layer may at least include a ninth gate electrode 29 and a third scan signal line 33, and the fourth conductive layer may at least include a data signal line and a high-frequency signal line, as shown in FIG. 18.

The preparation process described in the present embodiment is only an exemplary illustration, and the corresponding structure may be changed according to the actual connection relationship. For example, a connection hole exposing a surface of the first conductive layer may also be formed simultaneously in act (32). As another example, in act (35), a connection hole exposing a surface of the second conductive layer may also be formed simultaneously. The present disclosure is not specifically limited thereto.

In the display substrate provided by the embodiment of the disclosure, a shelter layer, which has a relatively generous layout space, is used as a transfer structure layer, and the second semiconductor layer is connected with the transfer structure layer through a via, which not only can effectively alleviate the layout pressure of a plurality of connection electrodes in the fourth conductive layer, be beneficial to the optimization of the layout structure, effectively improve the resolution, but also can reduce the depth of vias, reduce the process difficulty, improve the connection reliability and effectively improve the yield of product.

In an exemplary implementation, the scheme in which the shelter layer is used as the transfer structure layer and the scheme in which the third conductive layer is used as the transfer structure layer provided by the embodiments of the present disclosure may be combined, a part of the transfer electrodes may be provided on the shelter layer, and another part of the transfer electrodes may be provided on the third conductive layer, which will not be repeated here.

In one possible exemplary implementation, the display substrate of the present embodiment may only be provided with a shielding layer without a second conductive layer, and structures such as the second power supply line 37, the initial signal line 45, the third electrode plate 83, the fourth electrode plate 84, and the shielding line may be provided on the shielding layer, which will not be repeated here.

The display substrate provided by the exemplary embodiment of the present disclosure may be applied to any LED drive pixel circuit, including P-type Pulse Amplitude Modulation (PAM), P-type PAM + Pulse Width Modulation (PWM), N-type PAM, N-type PAM + PWM, LTPO-type PAM, and PAM + PWM circuits, and the like.

An exemplary embodiment of the present disclosure also provides a preparation method of a display substrate to prepare the aforementioned display substrate. In an exemplary implementation, the display substrate includes a plurality of circuit units forming a plurality of unit rows and a plurality of unit columns.

The preparation method includes: forming a pixel drive circuit, a first scan signal line, a second scan signal line, a third scan signal line and a light emitting signal line in at least one circuit unit, wherein the pixel drive circuit at least includes a first transistor, a second transistor, a third transistor, a fourth transistor, a fifth transistor, a sixth transistor, a seventh transistor, an eighth transistor, a ninth transistor and a tenth transistor. A gate electrode of the first transistor, a gate electrode of the seventh transistor and a gate electrode of the tenth transistor are electrically connected to the third scan signal line. A gate electrode of the second transistor is electrically connected to the second scan signal line. A gate electrode of the fourth transistor is electrically connected to the first scan signal line. A gate electrode of the fifth transistor is electrically connected to the light emitting signal line. A gate electrode of the eighth transistor is electrically connected to a gate electrode of the ninth transistor. An orthographic projection of the first scan signal line on a plane of the display substrate at least partially overlaps an orthographic projection of the second scan signal line on the plane of the display substrate, an orthographic projection of the third scan signal line on the plane of the display substrate at least partially overlaps an orthographic projection of the light emitting signal line on the plane of the display substrate, and an orthographic projection of the eighth transistor on the plane of the display substrate at least partially overlaps an orthographic projection of the ninth transistor on the plane of the display substrate.

An exemplary embodiment of the present disclosure also provides a display apparatus, which includes the display substrate of the foregoing embodiments. The display apparatus may be any product or component with a display function, such as a mobile phone, a tablet computer, a television, a display, a laptop computer, a digital photo frame, or a navigator.

Although implementations disclosed in the present disclosure are as above, it should be noted that the above implementations are exemplary only rather than restrictive. Therefore, the present disclosure is not limited to the contents specifically shown and described herein. Various modifications, substitutions or omissions may be made in forms and details of implementations without departing from the scope of the present disclosure.

## Claims

1. A display substrate, comprising a plurality of circuit units forming a plurality of unit rows and a plurality of unit columns, wherein at least one circuit unit comprises a pixel drive circuit, a first scan signal line, a second scan signal line, a third scan signal line, and a light emitting signal line, the pixel drive circuit at least comprises a first transistor, a second transistor, a third transistor, a fourth transistor, a fifth transistor, a sixth transistor, a seventh transistor, an eighth transistor, a ninth transistor, and a tenth transistor; a gate electrode of the first transistor, a gate electrode of the seventh transistor and a gate electrode of the tenth transistor are electrically connected to the third scan signal line, a gate electrode of the second transistor is electrically connected to the second scan signal line, a gate electrode of the fourth transistor is electrically connected to the first scan signal line, a gate electrode of the fifth transistor is electrically connected to the light emitting signal line, and a gate electrode of the eighth transistor is electrically connected to a gate electrode of the ninth transistor; an orthographic projection of the first scan signal line on a plane of the display substrate at least partially overlaps an orthographic projection of the second scan signal line on the plane of the display substrate, an orthographic projection of the third scan signal line on the plane of the display substrate at least partially overlaps an orthographic projection of the light emitting signal line on the plane of the display substrate, and an orthographic projection of the eighth transistor on the plane of the display substrate at least partially overlaps an orthographic projection of the ninth transistor on the plane of the display substrate.

2. The display substrate according to claim 1, wherein the first transistor, the second transistor, the seventh transistor, the ninth transistor, and the tenth transistor are oxide transistors, and the third transistor, the fourth transistor, the fifth transistor, the sixth transistor, and the eighth transistor are polysilicon transistors.

3. The display substrate according to claim 1, wherein an orthographic projection of the gate electrode of the eighth transistor on the plane of the display substrate at least partially overlaps an orthographic projection of the gate electrode of the ninth transistor on the plane of the display substrate.

4. The display substrate according to claim 1, wherein an orthographic projection of an active layer of the eighth transistor on the plane of the display substrate at least partially overlaps an orthographic projection of an active layer of the ninth transistor on the plane of the display substrate.

5. The display substrate according to claim 1, wherein an orthographic projection of a channel region of the eighth transistor on the plane of the display substrate at least partially overlaps an orthographic projection of a channel region of the ninth transistor on the plane of the display substrate.

6. The display substrate according to claim 1, wherein, in at least one unit row, pixel drive circuits in two adjacent circuit units are mirror symmetrical with respect to a column dividing line, which is a straight line located between adjacent unit columns and extending in a pixel column direction.

7. The display substrate according to claim 1, wherein, in at least one unit column, pixel drive circuits in two adjacent circuit units are mirror symmetrical with respect to a row dividing line which is a straight line located between adjacent unit rows and extending in a pixel row direction.

8. The display substrate according to claim 1, wherein, in at least one unit column, first electrodes of first transistors in two adjacent circuit units are connected to a same initial signal line, and first electrodes of seventh transistors in two adjacent circuit units are connected to a same initial signal line.

9. The display substrate according to claim 1, wherein, in at least one unit column, active layers of first transistors in two adjacent circuit units are of an interconnected integral structure, and active layers of seventh transistors in two adjacent circuit units are of an interconnected integral structure.

10. The display substrate according to claim 1, wherein, in at least one unit row, first electrodes of eighth transistors in two adjacent circuit units are connected to a same high-frequency signal line.

11. The display substrate according to claim 1, wherein, in at least one unit row, active layers of eighth transistors in two adjacent circuit units are of an interconnected integral structure.

12. The display substrate according to any one of claims 1 to 11, wherein, in a direction perpendicular to the display substrate, the display substrate comprises a first semiconductor layer, a first conductive layer, a second conductive layer, a second semiconductor layer, and a third conductive layer that are sequentially disposed on a base substrate; an active layer of the third transistor, an active layer of the fourth transistor, an active layer of the fifth transistor, an active layer of the sixth transistor and an active layer of the eighth transistor are disposed in the first semiconductor layer, the first scan signal line, the light emitting signal line and the gate electrode of the eighth transistor are disposed in the first conductive layer, an active layer of the first transistor, an active layer of the second transistor, an active layer of the seventh transistor, an active layer of the ninth transistor and an active layer of the tenth transistor are disposed in the second semiconductor layer, and the second scan signal line, the third scan signal line and the gate electrode of the ninth transistor are disposed in the third conductive layer.

13. The display substrate according to claim 12, wherein the display substrate further comprises a first shielding line disposed between the third scan signal line and the light emitting signal line in the direction perpendicular to the display substrate, an orthographic projection of the first shielding line on the base substrate at least partially overlaps an orthographic projection of the light emitting signal line on the base substrate, and the orthographic projection of the first shielding line on the base substrate at least partially overlaps an orthographic projection of the third scan signal line on the base substrate.

14. The display substrate according to claim 12, wherein the display substrate further comprises a second shielding line disposed between the first scan signal line and the second scan signal line in the direction perpendicular to the display substrate, an orthographic projection of the second shielding line on the base substrate overlaps at least partially an orthographic projection of the first scan signal line on the base substrate, and the orthographic projection of the second shielding line on the base substrate overlaps at least partially an orthographic projection of the second scan signal line on the base substrate.

15. The display substrate according to claim 12, wherein the display substrate further comprises a fourth conductive layer disposed on a side of the third conductive layer away from the base substrate; the fourth conductive layer at least comprises an interconnection electrode connected with the active layer of the eighth transistor and the active layer of the ninth transistor, respectively.

16. The display substrate according to claim 15, wherein one end of the interconnection electrode is connected to the active layer of the eighth transistor through one via, and the other end of the interconnection electrode is connected to the active layer of the ninth transistor through another via.

17. The display substrate according to claim 15, wherein the interconnection electrode is lapped with a first surface of the active layer of the eighth transistor through one lap hole and lapped with a second surface of the active layer of the ninth transistor through the lap hole, the first surface is a surface parallel to the base substrate, and the second surface is a surface intersecting the base substrate.

18. The display substrate according to claim 15, wherein the third conductive layer further comprises a transfer electrode; the transfer electrode is connected to the active layer of the eighth transistor through one transfer hole, one end of the interconnection electrode is connected to a first transfer electrode through one via, and the other end of the interconnection electrode is connected to the active layer of the ninth transistor through another via.

19. The display substrate according to claim 15, wherein the display substrate further comprises a shielding layer disposed between the first conductive layer and the second conductive layer, the shielding layer comprises a transfer electrode; the transfer electrode is connected to the active layer of the eighth transistor through one transfer hole, one end of the interconnection electrode is connected to the transfer electrode through one via, and the other end of the interconnection electrode is connected to the active layer of the ninth transistor through another via.

20. The display substrate according to claim 12, wherein the second conductive layer comprises a transfer electrode; the transfer electrode is connected to the active layer of the eighth transistor through one transfer hole, and the active layer of the ninth transistor is connected to the transfer electrode through another transfer hole.

21. The display substrate according to claim 12, wherein the display substrate further comprises a shielding layer disposed between the first conductive layer and the second conductive layer, the shielding layer comprises a transfer electrode; the transfer electrode is connected to the active layer of the eighth transistor through one transfer hole, and the active layer of the ninth transistor is connected to the transfer electrode through another transfer hole.

22. A display apparatus, comprising the display substrate according to any one of claims 1 to 21.

23. A preparation method for a display substrate, the display substrate comprising a plurality of circuit units forming a plurality of unit rows and a plurality of unit columns, the preparation method comprising:
forming a pixel drive circuit, a first scan signal line, a second scan signal line, a third scan signal line and a light emitting signal line in at least one circuit unit, wherein the pixel drive circuit at least comprises a first transistor, a second transistor, a third transistor, a fourth transistor, a fifth transistor, a sixth transistor, a seventh transistor, an eighth transistor, a ninth transistor and a tenth transistor; a gate electrode of the first transistor, a gate electrode of the seventh transistor and a gate electrode of the tenth transistor are electrically connected to the third scan signal line, a gate electrode of the second transistor is electrically connected to the second scan signal line, a gate electrode of the fourth transistor is electrically connected to the first scan signal line, a gate electrode of the fifth transistor is electrically connected to the light emitting signal line, and a gate electrode of the eighth transistor is electrically connected to a gate electrode of the ninth transistor; an orthographic projection of the first scan signal line on a plane of the display substrate at least partially overlaps an orthographic projection of the second scan signal line on the plane of the display substrate, an orthographic projection of the third scan signal line on the plane of the display substrate at least partially overlaps an orthographic projection of the light emitting signal line on the plane of the display substrate, and an orthographic projection of the eighth transistor on the plane of the display substrate at least partially overlaps an orthographic projection of the ninth transistor on the plane of the display substrate.
